# EUROPEAN PATENT APPLICATION

(11) **EP 4 223 846 A1**
(43) Date of publication of application: **09.08.2023**
(21) Application number: 21874896.0
(22) Date of filing: 02.08.2021
(51) Int. Cl.: C09D 11/00, C09D 11/52, H05K 3/10

(54) **INK SET, LAMINATE, AND METHOD FOR PRODUCING LAMINATE**

(30) Priority: 30.09.2020 US 202063085155 P
(71) Applicant: FUJIFILM Corporation, Tokyo 106-8620 (JP)
(72) Inventor: FUJII, Yusuke, Santa Clara, California 95050 (US); YOKOI, Kazuhiro, Santa Clara, California 95050 (US); TAKAHASHI, Yohei, Santa Clara, California 95050 (US); TAKESHITA, Kohei, Ashigarakami-gun, Kanagawa 258-8577 (JP)
(74) Representative: Klunker IP Patentanwälte PartG mbB
(86) International application number: PCT/JP2021/028607
(87) International publication number: WO 2022/070593

(57) **Abstract**

Provided is an ink set containing an insulating ink that contains at least one polymerization initiator selected from the group consisting of an oxime compound, an alkylphenone compound, and a titanocene compound and a polymerizable monomer, and a conductive ink that contains at least one of a metal complex or a metal salt. Also provided are applications of the ink set.

## Description

### BACKGROUND OF THE INVENTION

### 1. Field of the Invention

The present disclosure relates to an ink set, a laminate, and a manufacturing method of a laminate.

### 2. Description of the Related Art

In a print substrate, sometimes noise such as electromagnetic wave noise or electrostatic noise is a problem. In the related art, a method of forming a conductive layer by thermal sintering using a silver particle ink is known.

For example, JP2003-183401A describes a curable resin composition containing a polycarboxylic acid resin (A) having two or more carboxyl groups in one molecule, a curable component (B), a curing agent (C), and a conductive filler (D) having a pH higher than 7.0. Furthermore, US10597547B describes an ink composition containing a silver complex.

### SUMMARY OF THE INVENTION

For a conductive layer provided on an insulating layer, conductivity improvement is required. In order to provide a conductive layer having higher conductivity on an insulating layer, the combination of an insulating ink for forming the insulating layer and a conductive ink for forming the conductive layer is important.

The present disclosure has been made in consideration of the above circumstances. According to an embodiment of the present invention, there is provided an ink set making it possible to obtain a laminate having excellent conductivity.

In addition, according to another embodiment of the present invention, there is provided a laminate having excellent conductivity and a manufacturing method of a laminate.

The present disclosure includes the following aspects.
<1> An ink set containing an insulating ink that contains at least one polymerization initiator selected from the group consisting of an oxime compound, an alkylphenone compound, and a titanocene compound and a polymerizable monomer, and a conductive ink that contains at least one of a metal complex or a metal salt.
<2> The ink set described in <1>, in which the polymerization initiator is an alkylphenone compound.
<3> The ink set described in <1> or <2>, in which the polymerization initiator is at least one compound selected from the group consisting of an α-aminoalkylphenone compound and a benzyl ketal alkylphenone compound.
<4> The ink set described in any one of <1> to <3>, in which a content of the polymerization initiator is 2% by mass to 10% by mass with respect to a total amount of the insulating ink.
<5> The ink set described in any one of <1> to <4>, in which a proportion of a polyfunctional polymerizable monomer in the polymerizable monomer is 50% by mass or less.
<6> The ink set described in any one of <1> to <5>, in which the insulating ink contains an N-vinyl compound.
<7> The ink set described in any one of <1> to <6>, in which a contact angle of the conductive ink on an insulating layer formed of the insulating ink is 60° or less.
<8> The ink set described in any one of <1> to <7>, in which the metal complex is a metal complex having a structure derived from at least one compound selected from the group consisting of an ammonium carbamate-based compound, an ammonium carbonate-based compound, an amine, and a carboxylic acid having 8 to 20 carbon atoms, and the metal salt is a metal carboxylate.
<9> The ink set described in any one of <1> to <8>, in which in a case where the insulating ink and the conductive ink have equal mass, a ratio of a mass of the polymerization initiator contained in the insulating ink to a total mass of a carboxylic acid an amine contained in the conductive ink is 0.06 to 0.5
<10> The ink set described in any one of <1> to <9>, in which the ink set is used for a print substrate.
<11> A manufacturing method of a laminate using the ink set described in any one of <1> to <10>, the manufacturing method including a step of obtaining an insulating layer by applying the insulating ink onto a base material, and a step of obtaining a conductive layer by applying the conductive ink onto the insulating layer.
<12> The manufacturing method of a laminate described in <11>, in which a ratio of a thickness of the conductive layer to a thickness of the insulating layer is less than 0.5.
<13> The manufacturing method of a laminate described in <11> or <12>, in which in the step of obtaining a conductive layer, the conductive ink is applied and then cured using heat or light.
<14> The manufacturing method of a laminate described in any one of <11> to <13>, in which in the step of obtaining a conductive layer, a step of applying the conductive ink is repeated two or more times.
<15> A laminate using the ink set described in any one of <1> to <10>, the laminate including a base material, an insulating layer that is a cured substance of the insulating ink provided on the base material, and a conductive layer that is a cured substance of the conductive ink provided on the insulating layer.

According to an embodiment of the present invention, there is provided an ink set making it possible to obtain a laminate having excellent conductivity.

Furthermore, according to another embodiment of the present invention, there are provided a laminate having excellent conductivity and a manufacturing method of a laminate.

### DESCRIPTION OF THE PREFERRED EMBODIMENTS

Hereinafter, the ink set, the laminate, and the manufacturing method of a laminate of the present disclosure will be specifically described.

In the present specification, a range of numerical values described using "to" means a range including numerical values described before and after "to" as a minimum value and a maximum value, respectively.

Regarding the ranges of numerical values described stepwise in the present specification, the upper limit or the lower limit described in a certain range of numerical values may be replaced with the upper limit or the lower limit of another range of numerical values described stepwise. In addition, in the ranges of numerical values described in the present specification, the upper limit or the lower limit described in a certain range of numerical values may be replaced with the value shown in Examples.

In the present specification, in a case where there is a plurality of substances in a composition that corresponds to each component of the composition, unless otherwise specified, the amount of each component of the composition means the total amount of the plurality of substances present in the composition.

In the present specification, a combination of two or more preferred embodiments is a more preferred embodiment.

In the present specification, the term "step" includes not only an independent step but also a step which is not clearly distinguished from another step as long as the intended purpose of the step is achieved.

In the present specification, "image" means general films, and "image recording" means the formation of an image (that is, a film). In the present specification, the concept of "image" also includes a solid image.

### [Ink set]

The ink set of the present disclosure contains an insulating ink that contains at least one polymerization initiator selected from the group consisting of an oxime compound, an alkylphenone compound, and a titanocene compound and a polymerizable monomer, and a conductive ink that contains at least one of a metal complex or a metal salt. Using the ink set of the present disclosure makes it possible to obtain a laminate having excellent conductivity. The reason is assumed to be as below.

The insulating ink in the ink set of the present disclosure contains a polymerization initiator and a polymerizable monomer. In a case where the insulating ink is irradiated, for example, with an active energy ray, due to radicals generated from the polymerization initiator, the polymerizable monomer is polymerized. By the polymerization of the polymerizable monomer, the insulating ink is cured and forms an insulating layer. Furthermore, by the application of the conductive ink onto the insulating layer and heating of the conductive ink, a conductive layer is formed. The inventors of the present invention have found that in a case where the migration of uncured components in the insulating layer to the conductive ink is suppressed during the formation of the insulating layer, conductivity is improved. Particularly, the inventors paid attention to a decomposition product of the polymerization initiator, as an uncured component in the insulating layer. The inventors have found that suppressing the migration of the decomposition product of the polymerization initiator to the conductive ink contributes to the conductivity improvement. It is considered that in the ink set of the present disclosure, at least one polymerization initiator that is contained in the insulating ink and selected from the group consisting of an oxime compound, an alkylphenone compound, and a titanocene compound is unlikely to migrate to the conductive ink even though the polymerization initiator is decomposed or unlikely to reduce conductivity even though the polymerization initiator is decomposed and migrates to the conductive ink.

In the ink set of the present disclosure, the conductive ink contains at least one of a metal complex or a metal salt. A conductive layer formed of the conductive ink containing at least one of the metal complex or the metal salt has fewer voids compared to a conductive layer formed of a conductive ink containing metal particles. Therefore, a laminate having excellent conductivity can be obtained.

For example, JP2003-183401A describes a curable resin composition containing a conductive filler. It is considered that a conductive layer formed of the curable resin composition containing a conductive filler cannot have high conductivity due to the presence of voids. Furthermore, JP2003-183401A has no description focusing on the combination of an insulating ink and a conductive ink.

Meanwhile, US10597547B describes an ink composition containing a silver complex. However, the specification of US10597547B also has no description focusing on the combination of an insulating ink and a conductive ink.

### <Insulating ink>

In the ink set of the present disclosure, the insulating ink contains at least one polymerization initiator selected from the group consisting of an oxime compound, an alkylphenone compound and a titanocene compound and a polymerizable monomer.

In the present disclosure, the insulating ink means an ink for forming an insulating layer having insulating properties. The insulating properties mean properties of having a volume resistivity of 10¹⁰ Ωcm or more.

### (Polymerization Initiator)

The insulating ink contains at least one polymerization initiator selected from the group consisting of an oxime compound, an alkylphenone compound and a titanocene compound.

Examples of the oxime compound include 1-[4-(phenylthio)phenyl]-1,2-octanedione-2-(O-benzoyloxime), 1-[9-ethyl-6-(2-methylbenzoyl)-9H-carbazol-3-yl]etanone-1-(O-acetyloxime), 3-benzoyloxyiminobutan-2-one, 3-acetoxyiminobutan-2-one, 3-propionyloxyiminobutan-2-one, 2-acetoxyiminopentan-3-one, 2-acetoxyimino-1-phenylpropan-1-one, 2-benzoyloxyimino-1-phenylpropan-1-one, 3-(4-toluenesulfonyloxy)iminobutan-2-one, and 2-ethoxycarbonyloxyimino-1-phenylpropan-1-one.

The oxime compound may be the compound described in JP2009-519904A in which oxime is linked to the N-position of a carbazole ring; the compound described in the specification of US7626957B in which a hetero substituent is introduced into a benzophenone moiety; the compound described in JP2010-15025 and US2009-292039A in which a nitro group is introduced into a colorant moiety; the ketoxime compound described in the specification of WO2009/131189A; the compound described in the specification of US7556910B that contains a triazine skeleton and an oxime skeleton in the same molecule; or the compound described in JP2009-221114A that has absorption maximum at 405 nm and has excellent sensitivity to a g-line light source.

The oxime compound may also be an oxime compound having a fluorene ring. Examples of the oxime compound having a fluorene ring include the compounds described in JP2014-137466A.

The oxime compound may also be an oxime compound having a benzofuran skeleton. Examples of the oxime compound having a benzofuran skeleton include the compounds OE-01 to OE-75 described in WO2015/036910A.

Furthermore, the oxime compound may be an oxime compound having a skeleton in which a naphthalene ring takes place of at least one of the benzene rings of a carbazole ring. Examples of such an oxime compound include the compounds described in WO2013/083505A.

The oxime compound may also be an oxime compound having a fluorine atom. Examples of the oxime compound having a fluorine atom include the compounds described in JP2010-262028A; compounds 24 and 36 to 40 described in JP2014-500852A; and the compound (C-3) described in JP2013-164471A.

The oxime compound may also be an oxime compound having a nitro group. The oxime compound having a nitro group may be a dimer. Examples of the oxime compound having a nitro group include the compounds described in paragraphs "0031" to "0047" of JP2013-114249A, paragraphs "0008" to "0012" and "0070" to "0079" of JP2014-137466A; the compounds described in paragraphs "0007" to "0025" of JP4223071B; and ADEKA ARKLS NCI-831 (manufactured by ADEKA CORPORATION).

Examples of commercially available products of the oxime compound include IRGACURE OXE01, IRGACURE OXE02, IRGACURE OXE03, and IRGACURE OXE04 (manufactured by BASF Japan Ltd.); TR-PBG-304, TR-PBG-309, and TR-PBG-305 (manufactured by CHANGZHOU TRONLY NEW ELECTRONIC MATERIALS CO., LTD.); and ADEKA ARKLS NCI-930 and ADEKA OPTOMER N-1919 (manufactured by ADEKA CORPORATION).

Examples of the alkylphenone compound include an α-hydroxyalkylphenone compound, an α-aminoalkylphenone compound, and a benzyl ketal alkylphenone compound.

Examples of the α-hydroxyalkylphenone compound include 2,2'-dihydroxy-2,2'-dimethyl-1,1'-[methylenebis(4,1-phenylene)]bis(propan-1-one), 1-[4-(2-hydroxyethoxy)phenyl]-2-methyl-2-hydroxy-1-propanone, 2-hydroxy-2-methyl-1-phenylpropan-1-one, and 1-hydroxycyclohexylphenylketone.

Examples of the α-aminoalkylphenone compound include 2-methyl-1-phenyl-2-morpholinopropan-1-one, 2-methyl-1-[4-(hexyl)phenyl]-2-morpholinopropan-1-one, 2-ethyl-2-dimethylamino-1-(4-morpholinophenyl)butan-1-one, 2-benzyl-2-dimethylamino-1 -(4-morpholinophenyl)-butan-1 -one, 2-dimethylamino-2-(4-methylbenzyl)-1-(4-morpholin-4-yl-phenyl)-butan-1-one, 2-methyl-1-[4-(methylthio)phenyl]-2-morpholinopropan-1-one, 2-(dimethylamino)-2-(4-methylbenzyl)-1-(4-morpholinophenyl)-butan-1-one, and 2-(dimethylamino)-2-[(4-methylphenyl)methyl]-1-[4-(4-morpholinyl)phenyl]-butan-1-one.

Examples of the benzyl ketal alkylphenone compound include an alkylphenone compound such as 2,2-dimethoxy-2-phenylacetophenone.

Examples of commercially available products of the alkylphenone compound include Omnirad 651, Omnirad 184, Omnirad 1173, Omnirad 2959, Omnirad 127, Omnirad 907, Omnirad 369, and Omnirad 369E (manufactured by IGM Resins B. V).

Examples of the titanocene compound include di-η(5)-cyclopentadienylbis [2,6-difluoro-3-(pyrrol-1 -yl)phenyl]titanium (IV), dicyclopentadienyl-titanium-dichloride, dicyclopentadienyl-titanium-bisphenyl, dicyclopentadienyl-titanium-bis-2,3,4,5,6-pentafluorophenyl-1-yl, dicyclopentadienyl-titanium-bis -2,3,5,6-tetrafluorophenyl-1-yl, dicyclopentadienyl-titanium-bis-2,4,6-trifluorophenyl-1-yl, dicyclopentadienyl-titanium-2,6-difluorophenyl-1-yl, dicyclopentadienyl-titanium-bis-2,4-difluorophenyl-1-yl, dimethylcyclopentadienyl-titanium-bis-2,3,4,5,6-pentafluorophenyl-1-yl, dimethylcyclopentadienyl-titanium-bis-2,3, 5,6-tetrafluorophenyl-1-yl, dimethylcyclopentadienyl-titanium-bis-2,4-difluorophenyl-1-yl, bis(cyclopentadienyl)-bis(2,6-difluoro-3-(pyri-1-yl)phenyl)titanium, bis(cyclopentadienyl)bis[2,6-difluoro-3-(methylsulfonamide)phenyl]titanium, and bis(cyclopentadienyl)bis[2,6-difluoro-3-(N-butylbiaroyl-amino)phenyl]titanium.

Among these, from the viewpoint of further improving conductivity, as the polymerization initiator contained in the insulating ink, an alkylphenone compound is preferable, and at least one compound selected from the group consisting of an α-aminoalkylphenone compound and a benzyl ketal alkylphenone compound is more preferable. It is considered that a decomposition product of an alkylphenone compound is unlikely to migrate to the conductive ink even though the alkylphenone compound is decomposed. Furthermore, it is considered that even though a decomposition product of an alkylphenone compound migrates to the conductive ink, the conductivity is unlikely to deteriorate.

The content of at least one polymerization initiator selected from the group consisting of an oxime compound, an alkylphenone compound, and a titanocene compound with respect to the total amount of the insulating ink is preferably 2% by mass to 10% by mass, and more preferably 3% by mass to 9% by mass. In a case where the content is 2% by mass or more, the adhesiveness between the insulating layer and the conductive layer is improved. On the other hand, in a case where the content is 10% by mass or less, the conductivity is improved, and the adhesiveness between the insulating layer and the conductive layer is improved.

The insulating ink may contain other polymerization initiators different from at least one polymerization initiator selected from the group consisting of an oxime compound, an alkylphenone compound and a titanocene compound. From the viewpoint of conductivity, it is preferable that the insulating ink do not contain other polymerization initiators.

Examples of other polymerization initiators include an acylphosphine oxide compound. In a case where the insulating ink contains other polymerization initiators, from the viewpoint of conductivity, the content of the other polymerization initiators is preferably 5% by mass or less with respect to the total amount of the insulating ink.

### (Polymerizable monomer)

The insulating ink contains at least one polymerizable monomer.

The polymerizable monomer means a monomer having at least one polymerizable group in one molecule. The polymerizable group in the polymerizable monomer may be a cationically polymerizable group or a radically polymerizable group. From the viewpoint of curing properties, the polymerizable group is preferably a radically polymerizable group. Furthermore, from the viewpoint of curing properties, the radically polymerizable group is preferably an ethylenically unsaturated group.

In the present disclosure, a monomer means a compound having a molecular weight of 1,000 or less. The molecular weight can be calculated from the type and number of atoms constituting the compound.

The polymerizable monomer may be a monofunctional polymerizable monomer having one polymerizable group or a polyfunctional polymerizable monomer having two or more polymerizable groups.

### -Monofunctional polymerizable monomer-

The monofunctional polymerizable monomer is not particularly limited as long as it is a monomer having one polymerizable group. From the viewpoint of curing properties, the monofunctional polymerizable monomer is preferably a monofunctional radically polymerizable monomer, and more preferably a monofunctional ethylenically unsaturated monomer.

Examples of the monofunctional ethylenically unsaturated monomer include monofunctional (meth)acrylate, monofunctional (meth)acrylamide, a monofunctional aromatic vinyl compound, monofunctional vinyl ether, and a monofunctional N-vinyl compound.

Examples of the monofunctional (meth)acrylate include methyl (meth)acrylate, ethyl (meth)acrylate, propyl (meth)acrylate, n-butyl (meth)acrylate, hexyl (meth)acrylate, 2-ethylhexyl (meth)acrylate, tert-octyl (meth)acrylate, isoamyl (meth)acrylate, decyl (meth)acrylate, isodecyl (meth)acrylate, lauryl (meth)acrylate, stearyl (meth)acrylate, isostearyl (meth)acrylate, cyclohexyl (meth)acrylate, 4-n-butylcyclohexyl (meth)acrylate, 4-tert-butylcyclohexyl (meth)acrylate, bornyl (meth)acrylate, isobornyl (meth)acrylate, 2-ethylhexyldiglycol (meth)acrylate, butoxyethyl (meth)acrylate, 2-chloroethyl (meth)acrylate, 4-bromobutyl (meth)acrylate, cyanoethyl (meth)acrylate, benzyl (meth)acrylate, butoxymethyl (meth)acrylate, 3-methoxybutyl (meth)acrylate, 2-(2-methoxyethoxy)ethyl (meth)acrylate, 2-(2-butoxyethoxy)ethyl (meth)acrylate, 2,2,2-tetrafluoroethyl (meth)acrylate, 1H,1H,2H,2H-perfluorodecyl (meth)acrylate, 4-butylphenyl (meth)acrylate, phenyl (meth)acrylate, 2,4,5-tetramethylphenyl (meth)acrylate, 4-chlorophenyl (meth)acrylate, 2-phenoxymethyl (meth)acrylate, 2-phenoxyethyl (meth)acrylate, glycidyl (meth)acrylate, glycidyloxybutyl (meth)acrylate, glycidyloxyethyl (meth)acrylate, glycidyloxypropyl (meth)acrylate, tetrahydrofurfuryl (meth)acrylate, 2-hydroxyethyl (meth)acrylate, 3-hydroxypropyl (meth)acrylate, 2-hydroxypropyl (meth)acrylate, 2-hydroxybutyl (meth)acrylate, 3-hydroxybutyl (meth)acrylate, 4-hydroxybutyl (meth)acrylate, cyclic trimethylolpropane formal(meth)acrylate, phenylglycidyl ether (meth)acrylate, dimethylaminoethyl (meth)acrylate, diethylaminoethyl (meth)acrylate, dimethylaminopropyl (meth)acrylate, diethylaminopropyl (meth)acrylate, trimethoxysilylpropyl (meth)acrylate, trimethylsilylpropyl (meth)acrylate, polyethylene oxide monomethyl ether (meth)acrylate, polyethylene oxide (meth)acrylate, polyethylene oxide monoalkyl ether (meth)acrylate, dipropylene glycol (meth)acrylate, polypropylene oxide monoalkyl ether (meth)acrylate, 2-methacryloyloxyethyl succinate, 2-methacryloyloxyhexahydrophthalic acid, 2-methacryloyloxyethyl-2-hydroxypropyl phthalate, ethoxydiethylene glycol (meth)acrylate, butoxydiethylene glycol (meth)acrylate, trifluoroethyl (meth)acrylate, perfluorooctylethyl (meth)acrylate, 2-hydroxy-3-phenoxypropyl (meth)acrylate, ethylene oxide (EO)-modified phenol (meth)acrylate, EO-modified cresol (meth)acrylate, EO-modified nonylphenol (meth)acrylate, propylene oxide (PO)-modified nonylphenol (meth)acrylate, EO-modified-2-ethylhexyl (meth)acrylate, dicyclopentenyl (meth)acrylate, dicyclopentenyloxyethyl (meth)acrylate, dicyclopentanyl (meth)acrylate, (3-ethyl-3-oxetanylmethyl) (meth)acrylate, phenoxyethylene glycol (meth)acrylate, 2-carboxyethyl (meth)acrylate, and 2-(meth)acryloyloxyethyl succinate.

Among these, from the viewpoint of improving heat resistance, the monofunctional (meth)acrylate is preferably a monofunctional (meth)acrylate having an aromatic ring or an aliphatic ring, and is more preferably isobornyl (meth)acrylate, 4-tert-butylcyclohexyl (meth)acrylate, dicyclopentenyl (meth)acrylate, or dicyclopentanyl (meth)acrylate.

Examples of the monofunctional (meth)acrylamide include (meth)acrylamide, N-methyl (meth)acrylamide, N-ethyl (meth)acrylamide, N-propyl (meth)acrylamide, N-n-butyl (meth)acrylamide, N-t-butyl (meth)acrylamide, N-butoxymethyl (meth)acrylamide, N-isopropyl (meth)acrylamide, N-methylol (meth)acrylamide, N,N-dimethyl (meth)acrylamide, N,N-diethyl (meth)acrylamide, and (meth)acryloylmorpholine.

Examples of the monofunctional aromatic vinyl compound include styrene, dimethylstyrene, trimethylstyrene, isopropylstyrene, chloromethylstyrene, methoxystyrene, acetoxystyrene, chlorostyrene, dichlorostyrene, bromostyrene, vinyl benzoic acid methyl ester, 3-methylstyrene, 4-methylstyrene, 3-ethylstyrene, 4-ethylstyrene, 3-propyl styrene, 4-propylstyrene, 3-butylstyrene, 4-butylstyrene, 3-hexylstyrene, 4-hexylstyrene, 3-octylstyrene, 4-octylstyrene, 3-(2-ethylhexyl)styrene, 4-(2-ethylhexyl)styrene, allyl styrene, isopropenyl styrene, butenyl styrene, octenyl styrene, 4-t-butoxycarbonyl styrene, and 4-t-butoxystyrene.

Examples of the monofunctional vinyl ether include methyl vinyl ether, ethyl vinyl ether, propyl vinyl ether, n-butyl vinyl ether, t-butyl vinyl ether, 2-ethylhexyl vinyl ether, n-nonyl vinyl ether, lauryl vinyl ether, cyclohexyl vinyl ether, cyclohexyl methyl vinyl ether, 4-methylcyclohexyl methyl vinyl ether, benzyl vinyl ether, dicyclopentenyl vinyl ether, 2-dicyclopentenoxyethyl vinyl ether, methoxyethyl vinyl ether, ethoxyethyl vinyl ether, butoxyethyl vinyl ether, methoxyethoxyethyl vinyl ether, ethoxyethoxyethyl vinyl ether, methoxypolyethylene glycol vinyl ether, tetrahydrofurfuryl vinyl ether, 2-hydroxyethyl vinyl ether, 2-hydroxypropyl vinyl ether, 4-hydroxybutyl vinyl ether, 4-hydroxymethylcyclohexylmethyl vinyl ether, diethylene glycol monovinyl ether, polyethylene glycol vinyl ether, chloroethyl vinyl ether, chlorobutyl vinyl ether, chloroethoxyethyl vinyl ether, phenylethyl vinyl ether, and phenoxypolyethylene glycol vinyl ether.

Examples of the monofunctional N-vinyl compound include N-vinyl-ε-caprolactam, N-vinylpyrrolidone, N-vinylformamide, and N-vinylphthalimide.

Among these, from the viewpoint of improving surface curing properties and adhesiveness, the monofunctional N-vinyl compound is preferably a compound having a heterocyclic structure.

### -Polyfunctional polymerizable monomer-

The polyfunctional polymerizable compound is not particularly limited as long as it is a monomer having two or more polymerizable groups. From the viewpoint of curing properties, the polyfunctional polymerizable compound is preferably a polyfunctional radically polymerizable monomer, and more preferably a polyfunctional ethylenically unsaturated monomer.

Examples of the polyfunctional ethylenically unsaturated monomer include a polyfunctional (meth)acrylate compound, a polyfunctional vinyl ether, and a polyfunctional allyl compound.

Examples of the polyfunctional (meth)acrylate include ethylene glycol di(meth)acrylate, diethylene glycol di(meth)acrylate, triethylene glycol di(meth)acrylate, polyethylene glycol di(meth)acrylate, propylene glycol di(meth)acrylate, dipropylene glycol di(meth)acrylate, tripropylene glycol di(meth)acrylate, polypropylene glycol di(meth)acrylate, butylene glycol di(meth)acrylate, tetraethylene glycol di(meth)acrylate, neopentyl glycol di(meth)acrylate, 3-methyl-1,5-pentanediol di(meth)acrylate, 1,6-hexanediol di(meth)acrylate, heptanediol di(meth)acrylate, EO-modified neopentyl glycol di(meth)acrylate, PO-modified neopentyl glycol di(meth)acrylate, EO-modified hexanediol di(meth)acrylate, PO-modified hexanediol di(meth)acrylate, octanediol di(meth)acrylate, nonanediol di(meth)acrylate, decanediol di(meth)acrylate, dodecanediol di(meth)acrylate, glycerin di(meth)acrylate, pentaerythritol di(meth)acrylate, ethylene glycol diglycidyl ether di(meth)acrylate, diethylene glycol diglycidyl ether di(meth)acrylate, tricyclodecanedimethanol di(meth)acrylate, trimethylolethane tri(meth)acrylate, trimethylolpropane tri(meth)acrylate, trimethylolpropane EO-added tri(meth)acrylate, pentaerythritol tri(meth)acrylate, pentaerythritol tetra(meth)acrylate, dipentaerythritol tetra(meth)acrylate, dipentaerythritol penta(meth)acrylate, dipentaerythritol hexa(meth)acrylate, tri(meth)acryloyloxyethoxytrimethylolpropane, glycerin polyglycidyl ether poly(meth)acrylate, and tris(2-acryloyloxyethyl) isocyanurate.

Examples of the polyfunctional vinyl ether include 1,4-butanediol divinyl ether, ethylene glycol divinyl ether, diethylene glycol divinyl ether, triethylene glycol divinyl ether, polyethylene glycol divinyl ether, propylene glycol divinyl ether, butylene glycol divinyl ether, hexanediol divinyl ether, 1,4-cyclohexanedimethanol divinyl ether, bisphenol A alkylene oxide divinyl ether, bisphenol F alkylene oxide divinyl ether, trimethylolethane trivinyl ether, trimethylolpropane trivinyl ether, ditrimethylolpropane tetravinyl ether, glycerin trivinyl ether, pentaerythritol tetravinyl ether, dipentaerythritol pentavinyl ether, dipentaerythritol hexavinyl ether, EO-added trimethylolpropane trivinyl ether, PO-added trimethylolpropane trivinyl ether, EO-added ditrimethylolpropane tetravinyl ether, PO-added ditrimethylolpropane tetravinyl ether, EO-added pentaerythritol tetravinyl ether, PO-added pentaerythritol tetravinyl ether, EO-added dipentaerythritol hexavinyl ether, and PO-added dipentaerythritol hexavinyl ether.

Examples of the polyfunctional allyl compound include triallyl isocyanurate, triallyl cyanurate, diallyl phthalate, diallyl isophthalate, diallyl terephthalate, triallyl trimellitate, and tetraallyl pyromellitate.

Among these, from the viewpoint of curing properties, the polyfunctional polymerizable monomer is preferably a monomer having 3 to 11 carbon atoms in a portion other than a (meth)acryloyl group. As the monomer having 3 to 11 carbon atoms in a portion other than a (meth)acryloyl group, specifically, 1,6-hexanediol di(meth)acrylate, dipropylene glycol di(meth)acrylate, PO-modified neopentyl glycol di(meth)acrylate, 1,4-butanediol di(meth)acrylate, 3-methyl-1,5-pentanediol di(meth)acrylate, polyethylene glycol di(meth)acrylate (EO chain n = 4), or 1,10-decanediol di(meth)acrylate is more preferable.

The proportion of the polyfunctional polymerizable monomer in the polymerizable monomer is preferably 60% by mass or less, more preferably 50% by mass or less, and even more preferably 40% by mass or less. In a case where the proportion of the polyfunctional polymerizable monomer in the polymerizable monomer is 60% by mass or less, the residual stress resulting from cure shrinkage is not too high, and the adhesiveness between the insulating layer and the conductive layer and the adhesiveness between the base material and the insulating layer are excellent. The lower limit of the proportion of the polyfunctional polymerizable monomer in the polymerizable monomer is preferably 0% by mass, and more preferably 20% by mass.

In the present disclosure, the insulating ink preferably contains an N-vinyl compound, and more preferably contains N-vinylcaprolactam. The N-vinyl compound is likely to be present at the air interface and has a function of enhancing the surface curing properties of the ink film. Therefore, in a case where the insulating ink contains the N-vinyl compound, uncured components in the insulating layer are inhibited from migrating to the conductive ink, which improves conductivity. In addition, because the N-vinyl compound has high polarity, the N-vinyl compound has a strong interaction with the conductive layer. Therefore, in a case where the insulating ink contains the N-vinyl compound, the adhesiveness between the insulating layer and the conductive layer is improved.

In the present disclosure, the insulating ink may contain other components different from the polymerization initiator and the polymerizable monomer. Examples of the other components include a sensitizer, a surfactant, and additives.

### (Sensitizer)

The insulating ink may contain at least one sensitizer.

Examples of the sensitizer include a polynuclear aromatic compound (for example, pyrene, perylene, triphenylene, and 2-ethyl-9,10-dimethoxyanthracene), a xanthene-based compound (for example, fluorescein, eosin, erythrosin, rhodamine B, and rose bengal), a cyanine-based compound (for example, thiacarbocyanine and oxacarbocyanine), a merocyanine-based compound (for example, merocyanine and carbomerocyanine), a thiazine-based compound (for example, thionine, methylene blue, and toluidine blue), an acridine-based compound (for example, acridine orange, chloroflavine, and acryflavine), an anthraquinones (for example, anthraquinone), a squarylium-based compound (for example, squarylium), a coumarin-based compound (for example, 7-diethylamino-4-methylcoumarin), a thioxanthone-based compound (for example, isopropylthioxanthone), and a thiochromanone-based compound (for example, thiochromanone). Among these, as the sensitizer, a thioxanthone-based compound is preferable.

Examples of the thioxanthone-based compound include thioxanthone, 2-isopropylthioxanthone, 4-isopropylthioxanthone, 2-chlorothioxanthone, 2,4-dichlorothioxanthone, 2-dodecylthioxanthone, 2,4-diethylthioxanthone, 2,4-dimethylthioxanthone, 1-methoxycarbonylthioxanthone, 2-ethoxycarbonylthioxanthone, 3-(2-methoxyethoxycarbonyl)thioxanthone, 4-butoxycarbonylthioxanthone, 3-butoxycarbonyl-7-methylthioxanthone, 1-cyano-3-chlorothioxanthone, 1-ethoxycarbonyl-3-chlorothioxanthone, 1 -ethoxycarbonyl-3 -ethoxythioxanthone, 1-ethoxycarbonyl-3-aminothioxanthone, 1-ethoxycarbonyl-3-phenylsulfurylthioxanthone, 3,4-di[2-(2-methoxyethoxy)ethoxycarbonyl]thioxanthone, 1 -ethoxycarbonyl-3 -(1 -methyl-1 -morpholinoethyl)thioxanthone, 2-methyl-6-dimethoxymethylthioxanthone, 2-methyl-6-(1,1-dimethoxybenzyl)thioxanthone, 2-morpholinomethylthioxanthone, 2-methyl-6-morpholinomethylthioxanthone, n-allylthioxanthone-3,4-dicarboximide, n-octylthioxanthone-3,4-dicarboximide, N-(1,1,3,3-tetramethylbutyl)thioxanthone-3,4-dicarboximide, 1-phenoxythioxanthone, 6-ethoxycarbonyl-2-methoxythioxanthone, 6-ethoxycarbonyl-2-methylthioxanthone, thioxanthone-2-polyethylene glycol ester, and 2-hydroxy-3-(3,4-dimethyl-9-oxo-9H-thioxanthon-2-yloxy)-N,N,N-trimethyl-1-propanaminiu m chloride.

Examples of commercially available products of the thioxanthone-based compound include a SPEEDCURE series manufactured by Lambson Ltd., for example, SPEEDCURE ITX (2-isopropylthioxanthone).

In a case where the insulating ink contains a sensitizer, the content of the sensitizer is not particularly limited, but is preferably 1.0% by mass to 15.0% by mass and more preferably 1.5% by mass to 5.0% by mass with respect to the total amount of the insulating ink.

The mass ratio of the content of the polymerization initiator to the content of the sensitizer is preferably more than 1, and more preferably more than 1.5. The upper limit of the mass ratio is not particularly limited and is, for example, 10.

### (Chain transfer agent)

An ink for forming an insulating protective layer may contain at least one chain transfer agent.

From the viewpoint of improving the reactivity of a photopolymerization reaction, the chain transfer agent is preferably a polyfunctional thiol.

Examples of the polyfunctional thiol include aliphatic thiols such as hexane-1,6-dithiol, decane-1,10-dithiol, dimercaptodiethyl ether, and dimercaptodiethyl sulfide, aromatic thiols such as xylylene dimercaptan, 4,4'-dimercaptodiphenylsulfide, and 1,4-benzenedithiol;
poly(mercaptoacetate) of a polyhydric alcohol such as ethylene glycol bis(mercaptoacetate), polyethylene glycol bis(mercaptoacetate), propylene glycol bis(mercaptoacetate), glycerin tris(mercaptoacetate), trimethylolethane tris(mercaptoacetate), trimethylolpropane tris(mercaptoacetate), pentaerythritol tetrakis(mercaptoacetate), and dipentaerythritol hexakis(mercaptoacetate);
poly(3-mercaptopropionate) of a polyhydric alcohol such as ethylene glycol bis(3-mercaptopropionate), polyethylene glycol bis(3-mercaptopropionate), propylene glycol bis(3-mercaptopropionate), glycerin tris(3-mercaptopropionate), trimethylolethane tris(mercaptopropionate), trimethylolpropane tris(3-mercaptopropionate), pentaerythritol tetrakis(3-mercaptopropionate), and dipentaerythritol hexakis(3-mercaptopropionate);
poly(mercaptobutyrate) such as 1,4-bis(3-mercaptobutyryloxy)butane, 1,3,5-tris(3-mercaptobutyloxyethyl)-1,3,5-triazine-2,4,6(1H,3H,5H)-trione, and pentaerythritol tetraki s(3 -mercaptobutyrate).

### (Surfactant)

The insulating ink may contain at least one surfactant.

Examples of the surfactant include the surfactants described in JP1987-173463A (JP-S62-173463A) and JP1987-183457A (JP-S62-183457A). Examples of the surfactant include anionic surfactants such as dialkyl sulfosuccinate, alkyl naphthalene sulfonate, and a fatty acid salt, nonionic surfactants such as polyoxyethylene alkyl ether, polyoxyethylene alkyl allyl ether, acetylene glycol, and a polyoxyethylene·polyoxypropylene block copolymer, and cationic surfactants such as an alkylamine salt and a quaternary ammonium salt. The surfactant may also be a fluorine-based surfactant or a silicone-based surfactant.

In a case where the insulating ink contains a surfactant, the content of the surfactant with respect to the total amount of the insulating ink is preferably 3% by mass or less, and more preferably 1% by mass or less. The lower limit of the content of the surfactant is not particularly limited.

### (Organic solvent)

The insulating ink may contain at least one organic solvent.

Examples of the organic solvent include (poly)alkylene glycol monoalkyl ethers such as ethylene glycol monoethyl ether, diethylene glycol monoethyl ether, triethylene glycol monomethyl ether, propylene glycol monomethyl ether (PGME), dipropylene glycol monomethyl ether, and tripropylene glycol monomethyl ether;
(poly)alkylene glycol dialkyl ethers such as ethylene glycol dibutyl ether, diethylene glycol dimethyl ether, diethylene glycol diethyl ether, dipropylene glycol diethyl ether, and tetraethylene glycol dimethyl ether;
(poly)alkylene glycol acetates such as diethylene glycol acetate;
(poly)alkylene glycol diacetates such as ethylene glycol diacetate and propylene glycol diacetate;
(poly)alkylene glycol monoalkyl ether acetates such as ethylene glycol monobutyl ether acetate and propylene glycol monomethyl ether acetate, ketones such as methyl ethyl ketone and cyclohexanone;
lactones such as γ-butyrolactone;
esters such as ethyl acetate, propyl acetate, butyl acetate, 3-methoxybutyl acetate (MBA), methyl propionate, and ethyl propionate;
cyclic ethers such as tetrahydrofuran and dioxane; and
amides such as dimethylformamide and dimethylacetamide.

In a case where the insulating ink contains an organic solvent, the content of the organic solvent with respect to the total amount of the insulating ink is preferably 80% by mass or less, and more preferably 60% by mass or less. The lower limit of the content of the organic solvent is not particularly limited.

### (Additive)

As necessary, the insulating ink may contain additives such as a co-sensitizer, an ultraviolet absorber, an antioxidant, an antifading agent, and a basic compound.

### (Physical properties)

From the viewpoint of improving jetting stability in a case where the insulating ink is applied using an ink jet recording method, the pH of the insulating ink is preferably 7 to 10, and more preferably 7.5 to 9.5. The pH is measured at 25°C by using a pH meter, for example, a pH meter (model number "HM-31") manufactured by DKK-TOA CORPORATION.

From the viewpoint of controlling the film thickness of the insulating layer, the viscosity of the insulating ink is preferably 0.5 mPa·s to 100 mPa·s, more preferably 2 mPa·s to 80 mPa·s, and even more preferably 3 mPa·s to 60 mPa·s. The viscosity is measured at 25°C by using a viscometer, for example, a TV-22 viscometer manufactured by TOKISANGYO.

From the viewpoint of controlling the film thickness of the insulating layer, the surface tension of the insulating ink is preferably 60 mN/m or less, more preferably 20 mN/m to 50 mN/m, and even more preferably 25 mN/m to 45 mN/m. The surface tension is measured at 25°C by using a surface tensiometer, for example, an automatic surface tensiometer (trade name "CBVP-Z") manufactured by Kyowa Interface Science Co., Ltd, by a plate method.

### <Conductive ink>

In the ink set of the present disclosure, the conductive ink contains at least one of a metal complex or a metal salt.

In the present disclosure, the conductive ink means an ink for forming a conductive layer having conductivity. "Conductivity" means properties of having a volume resistivity less than 10⁸ Ωcm.

### (Metal complex)

Examples of metals constituting the metal complex include silver, copper, gold, aluminum, magnesium, tungsten, molybdenum, zinc, nickel, iron, platinum, tin, copper, and lead. Among these, from the viewpoint of conductivity, the metal constituting the metal complex preferably includes at least one metal selected from the group consisting of silver, gold, platinum, nickel, palladium, and copper, and more preferably includes silver.

The metal complex can be obtained, for example, by reacting a metal salt with a complexing agent. Examples of the manufacturing method of the metal complex include a method of adding a metal salt and a complexing agent to an organic solvent and stirring the mixture for a predetermined time. The stirring method is not particularly limited, and can be appropriately selected from known methods such as a stirring method using a stirrer, a stirring blade, or a mixer, and a method of applying ultrasonic waves.

Examples of the metal salt include a metal oxide, thiocyanate, sulfide, chloride, cyanide, cyanate, carbonate, acetate, nitrate, nitrite, sulfate, phosphate, perchlorate, tetrafluoroborate, an acetyl acetonate complex salt, and carboxylate.

Examples of the complexing agent include an amine, an ammonium carbamate-based compound, an ammonium carbonate-based compound, an ammonium bicarbonate compound, and a carboxylic acid. Among these, from the viewpoint of conductivity, it is preferable that the complexing agent include at least one compound selected from the group consisting of an ammonium carbamate-based compound, an ammonium carbonate-based compound, an amine, and a carboxylic acid having 8 to 20 carbon atoms.

The metal complex has a structure derived from a complexing agent. It is preferable that the metal complex have a structure derived from at least one compound selected from the group consisting of an ammonium carbamate-based compound, an ammonium carbonate-based compound, an amine, and a carboxylic acid having 8 to 20 carbon atoms.

Examples of the amine as a complexing agent include ammonia, a primary amine, a secondary amine, a tertiary amine, and a polyamine.

Examples of the primary amine having a linear alkyl group include methylamine, ethylamine, 1-propylamine, n-butylamine, n-pentylamine, n-hexylamine, heptylamine, octylamine, nonylamine, n-decylamine, undecylamine, dodecylamine, tridecylamine, tetradecylamine, pentadecylamine, hexadecylamine, heptadecylamine, and octadecylamine.

Examples of the primary amine having a branched alkyl group include isopropylamine, sec-butylamine, tert-butylamine, isopentylamine, 2-ethylhexylamine, and tert-octylamine.

Examples of the primary amine having an alicyclic structure include cyclohexylamine and dicyclohexylamine.

Examples of the primary amine having a hydroxyalkyl group include ethanolamine, diethanolamine, triethanolamine, N-methylethanolamine, propanolamine, isopropanolamine, dipropanolamine, diisopropanolamine, tripropanolamine, and triisopropanolamine.

Examples of the primary amine having an aromatic ring include benzylamine, N,N-dimethylbenzylamine, phenylamine, diphenylamine, triphenylamine, aniline, N,N-dimethylaniline, N,N-dimethyl-p-toluidine, 4-aminopyridine, and 4-dimethylaminopyridine.

Examples of the secondary amine include dimethylamine, diethylamine, dipropylamine, dibutylamine, diphenylamine, dicyclopentylamine, and methylbutylamine.

Examples of the tertiary amine include trimethylamine, triethylamine, tripropylamine, and triphenylamine.

Examples of the polyamine include ethylenediamine, 1,3-diaminopropane, diethylenetriamine, triethylenetetramine, tetramethylenepentamine, hexamethylenediamine, tetraethylenepentamine, and a combination of these.

The amine is preferably an alkylamine, more preferably an alkylamine having 3 to 10 carbon atoms, and even more preferably a primary alkylamine having 4 to 10 carbon atoms.

The metal complex may be configured with one amine or two or more amines.

In reacting the metal salt with an amine, the ratio of the molar amount of the amine to the molar amount of the metal salt is preferably 1/1 to 15/1, and more preferably 1.5/1 to 6/1. In a case where the above ratio is within the above range, the complex formation reaction goes to completion, and a transparent solution is obtained.

Examples of the ammonium carbamate-based compound as a complexing agent include ammonium carbamate, methylammonium methylcarbamate, ethylammonium ethylcarbamate, 1-propylammonium 1-propylcarbamate, isopropylammonium isopropylcarbamate, butylammonium butylcarbamate, isobutylammonium isobutylcarbamate, amylammonium amylcarbamate, hexylammonium hexylcarbamate, heptylammonium heptylcarbamate, octylammonium octylcarbamate, 2-ethylhexylammonium 2-ethylhexylcarbamate, nonylammonium nonylcarbamate, and decylammonium decylcarbamate.

Examples of the ammonium carbonate-based compound as a complexing agent include ammonium carbonate, methylammonium carbonate, ethylammonium carbonate, 1-propylammonium carbonate, isopropylammonium carbonate, butylammonium carbonate, isobutylammonium carbonate, amylammonium carbonate, hexylammonium carbonate, heptylammonium carbonate, octylammonium carbonate, 2-ethylhexylammonium carbonate, nonylammonium carbonate, and decylammonium carbonate.

Examples of the ammonium bicarbonate-based compound as a complexing agent include ammonium bicarbonate, methylammonium bicarbonate, ethylammonium bicarbonate, 1-propylammonium bicarbonate, isopropylammonium bicarbonate, butylammonium bicarbonate, isobutylammonium bicarbonate, amylammonium bicarbonate, hexylammonium bicarbonate, heptylammonium bicarbonate, octylammonium bicarbonate, 2-ethylhexylammonium bicarbonate, nonylammonium bicarbonate, and decylammonium bicarbonate.

In reacting the metal salt with an ammonium carbamate-based compound, an ammonium carbonate-based compound, or an ammonium bicarbonate-based compound, the ratio of the molar amount of the ammonium carbamate-based compound, the ammonium carbonate-based compound, or the ammonium bicarbonate-based compound to the molar amount of the metal salt is preferably 0.01/1 to 1/1, and more preferably 0.05/1 to 0.6/1.

Examples of the carboxylic acid as a complexing agent include caproic acid, caprylic acid, pelargonic acid, 2-ethylhexanoic acid, capric acid, neodecanoic acid, undecanoic acid, lauric acid, myristic acid, palmitic acid, stearic acid, palmitoleic acid, oleic acid, linoleic acid, and linolenic acid. Among these, a carboxylic acid having 8 to 20 carbon atoms is preferable as the carboxylic acid.

### <Metal salt>

Examples of metals constituting the metal salt include silver, copper, gold, aluminum, magnesium, tungsten, molybdenum, zinc, nickel, iron, platinum, tin, copper, and lead. Among these, from the viewpoint of conductivity, the metal constituting the metal complex preferably includes at least one metal selected from the group consisting of silver, gold, platinum, nickel, palladium, and copper, and more preferably includes silver.

Examples of the metal salt include benzoate, halide, carbonate, citrate, iodate, nitrite, nitrate, acetate, phosphate, sulfate, sulfide, trifluoroacetate, and carboxylate of a metal. It should be noted that two or more salts may be combined.

From the viewpoint of conductivity and stability, the metal salt is preferably a metal carboxylate. The carboxylic acid forming the carboxylate is preferably at least one compound selected from the group consisting of formic acid and a fatty acid having 1 to 30 carbon atoms. In a case where the carboxylic acid is a fatty acid having 1 to 30 carbon atoms, the fatty acid may be linear or branched, or may have a substituent.

Examples of the linear fatty acid include acetic acid, propionic acid, butyric acid, valeric acid, pentanoic acid, hexanoic acid, heptanoic acid, behenic acid, oleic acid, octanoic acid, nonanoic acid, decanoic acid, caproic acid, enanthic acid, caprylic acid, pelargonic acid, capric acid, and undecanoic acid.

Examples of the branched fatty acid include isobutyric acid, isovaleric acid, ethylhexanoic acid, neodecanoic acid, pivalic acid, 2-methylpentanoic acid, 3-methylpentanoic acid, 4-methylpentanoic acid, 2,2-dimethylbutanoic acid, 2,3-dimethylbutanoic acid, 3,3-dimethylbutanoic acid, and 2-ethylbutanoic acid.

Examples of the carboxylic acid having a substituent include 3-hydroxybutyric acid, 2-methyl-3-hydroxybutyric acid, 3-methoxybutyric acid, acetonedicarboxylic acid, 3-hydroxyglutaric acid, 2-methyl-3 -hydroxy glutaric acid, hexafluoroacetylacetonate, hydroangelate, and 2,2,4,4-hydroxyglutaric acid.

The metal salt may be a commercially available product or may be manufactured by a known method. For example, a silver salt is manufactured by the following method.

First, a silver compound (for example, silver acetate) functioning as a silver supply source and formic acid or a fatty acid having 1 to 30 carbon atoms in the same quantity as the molar equivalent of the silver compound are added to an organic solvent such as ethanol. The mixture is stirred for a predetermined time by using an ultrasonic stirrer, and the formed precipitate is washed with ethanol and decanted. All of these steps can be performed at room temperature. The mixing ratio of the silver compound and the formic acid or fatty acid having 1 to 30 carbon atoms is preferably 1:2 to 2:1, and more preferably 1:1, in terms of molar ratio.

### (Solvent)

It is preferable that the conductive ink contain a solvent. The solvent is not particularly limited as long as it can dissolve components contained in the conductive ink, such as the metal complex and the metal salt. From the viewpoint of ease of manufacturing, the boiling point of the solvent is preferably 30°C to 300°C, more preferably 50°C to 200°C, and even more preferably 50°C to 150°C.

In a case where the conductive ink contains a metal complex, the content of the solvent in the conductive ink is preferably set such that the concentration of metal ions with respect to the metal complex (the amount of the metal present as free ions with respect to 1 g of the metal complex) is 0.01 mmol/g to 3.6 mmol/g, and more preferably set such that the aforementioned concentration of metal ions is 0.05 mmol/g to 2 mmol/g. In a case where the concentration of metal ions is within the above range, the metal complex ink has excellent fluidity and can obtain conductivity.

Examples of the solvent include a hydrocarbon, a cyclic hydrocarbon, an aromatic hydrocarbon, a carbamate, an alkene, an amide, an ether, an ester, an alcohol, a thiol, a thioether, phosphine, and water. The conductive ink may contain only one solvent or two or more solvents.

The hydrocarbon is preferably a linear or branched hydrocarbon having 6 to 20 carbon atoms. Examples of the hydrocarbon include pentane, hexane, heptane, octane, nonane, decane, undecane, dodecane, tridecane, tetradecane, pentadecane, hexadecane, octadecane, nonadecane, and icosane.

The cyclic hydrocarbon is preferably a cyclic hydrocarbon having 6 to 20 carbon atoms. The cyclic hydrocarbons can include, for example, cyclohexane, cycloheptane, cyclooctane, cyclononane, cyclodecane, and decalin.

Examples of the aromatic hydrocarbon include benzene, toluene, xylene, and tetraline.

The ether may be any of a linear ether, a branched ether, and a cyclic ether. Examples of the ether include diethyl ether, dipropyl ether, dibutyl ether, methyl-t-butyl ether, tetrahydrofuran, tetrahydropyrane, dihydropyrane, and 1,4-dioxane.

The alcohol may be any of a primary alcohol, a secondary alcohol, and a tertiary alcohol.

Examples of the alcohol include ethanol, 1-propanol, 2-propanol, 1-methoxy-2-propanol, 1-butanol, 2-butanol, 1-pentanol, 2-pentanol, 3-pentanol, 1-hexanol, 2-hexanol, 3-hexanol, 1-octanol, 2-octanol, 3-octanol, tetrahydrofurfuryl alcohol, cyclopentanol, terpineol, decanol, isodecyl alcohol, lauryl alcohol, isolauryl alcohol, myristyl alcohol, isomyristyl alcohol, cetyl alcohol (cetanol), isocetyl alcohol, stearyl alcohol, isostearyl alcohol, oleyl alcohol, isooleyl alcohol, linoleyl alcohol, isolinoleyl alcohol, palmityl alcohol, isopalmityl alcohol, icosyl alcohol, and isoicosyl alcohol.

Examples of the ketone include acetone, methyl ethyl ketone, methyl isobutyl ketone, and cyclohexanone.

Examples of the ester include methyl acetate, ethyl acetate, isopropyl acetate, butyl acetate, isobutyl acetate, sec-butyl acetate, methoxybutyl acetate, ethylene glycol monomethyl ether acetate, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, propylene glycol monomethyl ether acetate, propylene glycol monoethyl ether acetate, propylene glycol monobutyl ether acetate, dipropylene glycol monomethyl ether acetate, dipropylene glycol monoethyl ether acetate, dipropylene glycol monobutyl ether acetate, and 3-methoxybutyl acetate.

In a case where the conductive ink contains a metal salt, the content of the solvent in the conductive ink is preferably set such that the concentration of metal ions with respect to the metal salt (the amount of the metal present as free ions with respect to 1 g of the metal salt) is 0.01 mmol/g to 3.6 mmol/g, and more preferably set such that the aforementioned concentration of metal ions is 0.05 mmol/g to 2.6 mmol/g. In a case where the concentration of metal ions is within the above range, the conductive ink has excellent fluidity and can obtain electromagnetic wave shielding properties.

Examples of the solvent include a hydrocarbon, a cyclic hydrocarbon, an aromatic hydrocarbon, a carbamate, an alkene, an amide, an ether, an ester, an alcohol, a thiol, a thioether, phosphine, and water.

The metal salt ink may contain only one solvent or two or more solvents.

It is preferable that the solvent contain an aromatic hydrocarbon.

Examples of the aromatic hydrocarbon include benzene, toluene, xylene, ethylbenzene, propylbenzene, isopropylbenzene, butylbenzene, isobutylbenzene, t-butylbenzene, trimethylbenzene, pentylbenzene, hexylbenzene, tetraline, benzyl alcohol, phenol, cresol, methyl benzoate, ethyl benzoate, propyl benzoate, and butyl benzoate.

From the viewpoint of compatibility with other components, the number of aromatic rings in the aromatic hydrocarbon is preferably 1 or 2, and more preferably 1.

From the viewpoint of ease of manufacturing, the boiling point of the aromatic hydrocarbon is preferably 50°C to 300°C, more preferably 60°C to 250°C, and even more preferably 80°C to 200°C.

The solvent may contain an aromatic hydrocarbon and a hydrocarbon other than the aromatic hydrocarbon.

Examples of the hydrocarbon other than the aromatic hydrocarbon include a linear hydrocarbon having 6 to 20 carbon atoms, a branched hydrocarbon having 6 to 20 carbon atoms, and an alicyclic hydrocarbon having 6 to 20 carbon atoms.

Examples of the hydrocarbon other than the aromatic hydrocarbon include pentane, hexane, heptane, octane, nonane, decane, undecane, dodecane, tridecane, tetradecane, pentadecane, hexadecane, octadecane, nonadecane, decalin, cyclohexane, cycloheptane, cyclooctane, cyclononane, cyclodecane, decene, a terpene-based compound, and icosane.

It is preferable that the hydrocarbon other than the aromatic hydrocarbon contain an unsaturated bond.

Examples of the hydrocarbon containing an unsaturated bond other than the aromatic hydrocarbon include a terpene-based compound.

Depending on the number of isoprene units constituting the terpene-based compound, the terpene-based compound is classified into, for example, a hemiterpene, a monoterpene, a sesquiterpene, a diterpene, a sesterterpene, a triterpene, a sesquarterpene, and a tetraterpene.

The terpene-based compound as the solvent may be any of the above compounds, and is preferably a monoterpene.

Examples of the monoterpene include pinene (α-pinene and β-pinene), terpineol (α-terpineol, β-terpineol, and γ-terpineol), myrcene, camphene, limonene (d-limonene, l-limonene, and dipentene), ocimene (α-ocimene and β-ocimene), alloocimene, phellandrene (α-phellandrene and β-phellandrene), terpinene (α-terpinene and γ-terpinene), terpinolene (α-terpinolene, β-terpinolene, γ- terpinolene, and δ-terpinolene), 1,8-cineole, 1,4-cineole, sabinene, paramenthadiene, and carene (δ-3-carene).

As the monoterpene, a cyclic monoterpene is preferable, and pinene, terpineol, or carene is more preferable.

The ether may be any of a linear ether, a branched ether, and a cyclic ether. Examples of the ether include diethyl ether, dipropyl ether, dibutyl ether, methyl-t-butyl ether, tetrahydrofuran, tetrahydropyrane, dihydropyrane, and 1,4-dioxane.

The alcohol may be any of a primary alcohol, a secondary alcohol, and a tertiary alcohol.

Examples of the alcohol include ethanol, 1-propanol, 2-propanol, 1-methoxy-2-propanol, 1-butanol, 2-butanol, 1-pentanol, 2-pentanol, 3-pentanol, 1-hexanol, 2-hexanol, 3-hexanol, 1-octanol, 2-octanol, 3-octanol, tetrahydrofurfuryl alcohol, cyclopentanol, terpineol, decanol, isodecyl alcohol, lauryl alcohol, isolauryl alcohol, myristyl alcohol, isomyristyl alcohol, cetyl alcohol (cetanol), isocetyl alcohol, stearyl alcohol, isostearyl alcohol, oleyl alcohol, isooleyl alcohol, linoleyl alcohol, isolinoleyl alcohol, palmityl alcohol, isopalmityl alcohol, icosyl alcohol, and isoicosyl alcohol.

Examples of the ketone include acetone, methyl ethyl ketone, methyl isobutyl ketone, and cyclohexanone.

Examples of the ester include methyl acetate, ethyl acetate, isopropyl acetate, butyl acetate, isobutyl acetate, sec-butyl acetate, methoxybutyl acetate, ethylene glycol monomethyl ether acetate, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, propylene glycol monomethyl ether acetate, propylene glycol monoethyl ether acetate, propylene glycol monobutyl ether acetate, dipropylene glycol monomethyl ether acetate, dipropylene glycol monoethyl ether acetate, dipropylene glycol monobutyl ether acetate, and 3-methoxybutyl acetate.

### (Reducing agent)

The conductive ink may contain a reducing agent. In a case where the conductive ink contains a reducing agent, reduction of at least one of the metal complex or the metal salt into a metal is facilitated.

Examples of the reducing agent include a borohydride metal salt, an aluminum hydride salt, an amine, an alcohol, an organic acid (carboxylic acid and sulfonic acid), reduced sugar, a sugar alcohol, sodium sulfite, a hydrazine compound, dextrin, hydroquinone, hydroxylamine, ethylene glycol, glutathione, and an oxime compound.

The reducing agent may be the oxime compound described in JP2014-516463A. Examples of the oxime compound include acetone oxime, cyclohexanone oxime, 2-butanone oxime, 2,3-butanedione monoxime, dimethyl glyoxime, methyl acetoacetate monoxime, methyl pyruvate monoxime, benzaldehyde oxime, 1-indanone oxime, 2-adamantanone oxime, 2-methylbenzamide oxime, 3-methylbenzamide oxime, 4-methylbenzamide oxime, 3-aminobenzamide oxime, 4-aminobenzamide oxime, acetophenone oxime, benzamide oxime, and pinacolone oxime.

The conductive ink may contain only one reducing agent or two or more reducing agents.

The content of the reducing agent in the conductive ink is not particularly limited, but is preferably 0.1% by mass to 20% by mass, more preferably 0.3% by mass to 10% by mass, and even more preferably 1% by mass to 5% by mass.

### (Resin)

The conductive ink may contain a resin. In a case where the conductive ink contains a resin, the adhesiveness of the conductive ink to the base material is improved.

Examples of the resin include polyester, polyethylene, polypropylene, polyacetal, polyolefin, polycarbonate, polyamide, a fluororesin, a silicone resin, ethyl cellulose, hydroxyethyl cellulose, rosin, an acrylic resin, polyvinyl chloride, polysulfone, polyvinylpyrrolidone, polyvinyl alcohol, a polyvinyl-based resin, polyacrylonitrile, polysulfide, polyamideimide, polyether, polyarylate, polyether ether ketone, polyurethane, an epoxy resin, a vinyl ester resin, a phenol resin, a melamine resin, and a urea resin.

The conductive ink may contain only one resin or two or more resins.

### (Additive)

As long as the effects of the present disclosure are not reduced, the conductive ink may further contain additives such as an inorganic salt, an organic salt, an inorganic oxide such as silica, a surface conditioner, a wetting agent, a crosslinking agent, an antioxidant, a rust inhibitor, a heat-resistant stabilizer, a surfactant, a plasticizer, a curing agent, a thickener, and a silane coupling agent. In the conductive ink, the total content of additives is preferably 20% by mass or less with respect to the total amount of the conductive ink.

### (Physical properties)

From the viewpoint of improving jetting stability in a case where the conductive ink is applied using an inkjet recording method, the pH of the conductive ink is preferably 7 to 11.5, and more preferably 7.5 to 11. The pH is measured at 25°C by using a pH meter, for example, a pH meter (model number "HM-31") manufactured by DKK-TOA CORPORATION.

The viscosity of the conductive ink is not particularly limited. The viscosity of the conductive ink may be 1 mPa·s to 5,000 Pa·s, and is preferably 3 mPa·s to 100 Pa·s. In a case where the conductive ink is applied using a spray method or an ink jet recording method, the viscosity of the conductive ink is preferably 1 mPa·s to 100 mPa·s, more preferably 2 mPa·s to 50 mPa·s, and even more preferably 3 mPa·s to 30 mPa·s.

The viscosity of the conductive ink is measured at 25°C by using a viscometer, for example, a TV-22 viscometer manufactured by TOKISANGYO.

The surface tension of the conductive ink is preferably 60 mN/m or less, more preferably 20 mN/m to 50 mN/m, and even more preferably 25 mN/m to 45 mN/m. The surface tension is measured at 25°C by using a surface tensiometer, for example, an automatic surface tensiometer (trade name "CBVP-Z") manufactured by Kyowa Interface Science Co., Ltd, by a plate method.

As described above, the conductive ink contains at least one of a metal complex or a metal salt. The metal complex and the metal salt may contain a structure derived from a carboxylic acid and/or an amine. In addition, the conductive ink may contain a reducing agent. The conductive ink may contain a carboxylic acid or an amine as the reducing agent. Hereinafter, the structure derived from a carboxylic acid and/or an amine contained in the metal complex and the metal salt, and the carboxylic acid or amine included in the reducing agent will be collectively called carboxylic acid and amine.

The content of the carboxylic acid and amine is calculated from the area ratio (%) of the detected component in the measurement result of gas chromatography. As the measuring device, for example, "GAS CHROMATOGRAPH GC-2010 (trade name)" manufactured by Shimadzu Corporation, is used.

In a case where the insulating ink and the conductive ink in the ink set of the present disclosure have equal mass, the ratio of the mass of the polymerization initiator contained in the insulating ink to the total mass of the carboxylic acid and amine in the conductive ink (that is, mass of polymerization initiator contained in insulating ink/total mass of carboxylic acid and amine in conductive ink) is preferably 0.06 to 0.5. In a case where the ratio is 0.06 or more, the adhesiveness between the insulating layer and the conductive layer is excellent. In contrast, in a case where the ratio is 0.5 or less, the conductivity is excellent. From the viewpoint of improving the conductivity and the adhesiveness between the insulating layer and the conductive layer, the aforementioned ratio is more preferably 0.06 to 0.4, and even more preferably 0.06 to 0.3.

The contact angle of the conductive ink on the insulating layer formed of the insulating ink is preferably 60° or less, more preferably 50° or less, and even more preferably 40° or less. In a case where the contact angle is 60° or less, the conductive layer is likely to be uniformly formed. The lower limit of the contact angle is not particularly limited, and is, for example, 5°.

The contact angle of the conductive ink on the insulating layer formed of the insulating ink is measured, for example, by the following method.

First, the insulating ink is applied onto a base material and irradiated with an active energy ray to form an insulating layer. The conductive ink is added dropwise onto the formed insulating layer, and the contact angle is measured at 25°C by using a contact angle meter. The contact angle is measured using, for example, a contact angle meter (trade name "Drop master 500", manufactured by Kyowa Interface Science Co., Ltd.).

### (Use)

The ink set of the present disclosure is preferably used for a print substrate. That is, the ink set of the present disclosure is preferably an ink set for a print substrate.

A print substrate can be prepared by applying the insulating ink in the ink set of the present disclosure onto a base material to form an insulating layer, and then applying the conductive ink in the ink set of the present disclosure onto the insulating layer, and recording an image to be a wiring pattern. Furthermore, a print substrate may be prepared by mounting an electronic component such as a chip on a base material, applying the insulating ink on the mounted electronic component to form an insulating layer, and then applying the conductive ink in the ink set of the present disclosure onto the insulating layer to form a conductive layer.

An electromagnetic shield can be prepared by applying the insulating ink in the ink set of the present disclosure onto a base material to form an insulating layer, and then applying the conductive ink in the ink set of the present disclosure onto the insulating layer to cover the entire surface of the insulating layer with a conductive layer.

### [Manufacturing method of laminate]

The manufacturing method of a laminate of the present disclosure includes a step of obtaining an insulating layer by applying the insulating ink of the present disclosure onto a base material and a step of obtaining a conductive layer by applying the conductive ink of the present disclosure onto the insulating layer.

### (Step of obtaining insulating layer)

The material of the base material is not particularly limited, and can be selected depending on the purpose. Specifically, examples of the material of the base material include synthetic resins such as polyimide, polyethylene terephthalate, polybutylene terephthalate, polytrimethylene terephthalate, polyethylene naphthalate, polybutylene naphthalate, polycarbonate, polyurethane, polyethylene, polypropylene, polyvinyl chloride, polystyrene, polyvinyl acetate, an acrylic resin, an acrylonitrile styrene resin (AS resin), an acrylonitrile-butadiene-styrene copolymer (ABS resin), triacetyl cellulose, polyamide, polyacetal, polyphenylene sulfide, polysulfone, an epoxy resin, a glass epoxy resin, a melamine resin, a phenol resin, a urea resin, an alkyd resin, a fluororesin, and polylactic acid; inorganic materials such as copper, steel, aluminum, silicon, soda glass, alkali-free glass, and indium tin oxide (ITO); and papers such as base paper, art paper, coated paper, cast coated paper, resin coated paper, and synthetic paper. The base material may be composed of one layer or two or more layers. In a case where the base material is composed of two or more layers, two or more base materials made of different materials may be laminated.

The base material is preferably in the form of a sheet or film. The thickness of the base material is preferably 20 µm to 2,000 µm.

The base material may have an ink receiving layer. The thickness of the ink receiving layer is preferably 1 µm to 20 µm. In a case where the thickness of the ink receiving layer is 1 µm to 20 µm, the ink receiving layer can be more stably maintained. The ink receiving layer is a coating layer formed on the base material to absorb and fix ink.

The method of applying the insulating ink onto the base material is not particularly limited, and examples thereof include known methods such as a coating method, an ink jet recording method, and a dipping method. Among these, from the viewpoint of making it possible to form a thin insulating ink film by applying once a small amount of insulating ink by means of jetting, a method of applying the insulating ink by using an ink jet recording method is preferable.

The base material may be subjected to a pretreatment before the application of the insulating ink. Examples of the pretreatment include known methods such as an ozone treatment, a plasma treatment, a corona treatment, a primer treatment, and a roughening treatment.

The ink jet recording method may be any of an electric charge control method of jetting an ink by using electrostatic attraction force, a drop-on-demand method using the vibration pressure of a piezo element (pressure pulse method), an acoustic inkjet method of jetting an ink by using radiation pressure by means of converting electric signals into acoustic beams and irradiating the ink with the acoustic beams, and a thermal ink jet (Bubble Jet (registered trademark)) method of forming bubbles by heating an ink and using the generated pressure.

As the ink jet recording method, particularly, it is possible to effectively use the method described in JP1979-59936A (JP-S54-59936A), which is an ink jet recording method of causing an ink to experience a rapid volume change by the action of thermal energy and jetting the ink from a nozzle by using the acting force resulting from the change of state.

Regarding the inkjet recording method, the method described in paragraphs "0093" to "0105" of JP2003-306623A can also be referred to.

Examples of ink jet heads used in the inkjet recording method include inkjet heads for a shuttle method of using short serial heads that are caused to scan a base material in a width direction of the base material so as to perform recording and ink jet heads for a line method of using line heads that each consist of recording elements arranged for the entire area of each side of a base material.

In the line method, by causing the base material to be scanned in a direction intersecting with the arrangement direction of the recording elements, a pattern can be formed on the entire surface of the base material. Therefore, this method does not require a transport system such as a carriage that moves short heads for scanning.

Furthermore, in the line method, complicated scanning control for moving a carriage and a base material is not necessary, and only a base material moves. Therefore, the recording speed can be further increased in the single-pass method than in the shuttle method.

The amount of the insulating ink jetted from the ink jet head is preferably 1 pL (picoliter) to 100 pL, more preferably 3 pL to 80 pL, and even more preferably 3 pL to 20 pL.

In the manufacturing method of a laminate of the present disclosure, it is preferable that the insulating ink of the present disclosure be irradiated with an active energy ray after being applied onto the base material.

Examples of the active energy rays include ultraviolet rays, visible rays, and electron beams. Among these, ultraviolet rays (hereinafter, also called "UV") are preferable.

The peak wavelength of the ultraviolet rays is preferably 200 nm to 405 nm, more preferably 250 nm to 400 nm, and even more preferably 300 nm to 400 nm.

The exposure amount during the active energy ray irradiation is preferably 100 mJ/cm² to 5,000 J/cm², and more preferably 300 mJ/cm² to 1,500 mJ/cm².

As the light source for ultraviolet irradiation, a mercury lamp, a gas laser, and a solid-state laser are mainly used. A mercury lamp, a metal halide lamp, and an ultraviolet fluorescent lamp are widely known light sources. Being compact, highly efficient, low cost, and having a long life, UV-LED (light emitting diode) and UV-LD (laser diode) are promising light sources for ultraviolet irradiation. As the light source for ultraviolet irradiation, among these, a metal halide lamp, a high-pressure mercury lamp, a medium-pressure mercury lamp, a low-pressure mercury lamp, or UV-LED is preferable.

In the step of obtaining an insulating layer, in order to obtain an insulating layer having a desired thickness, the step of applying the insulating ink and irradiating the insulating ink with an active energy ray is preferably repeated two or more times.

The thickness of the insulating layer is preferably 5 µm to 5,000 µm, and more preferably 10 µm to 2,000 µm.

### (Step of obtaining conductive layer)

The method of applying the conductive ink onto the insulating layer is not particularly limited, and examples thereof include known methods such as a coating method, an ink jet recording method, and a dipping method. Among these, from the viewpoint of making it possible to form a thin conductive ink film by applying once a small amount of conductive ink by means of jetting, a method of applying the conductive ink by using an ink jet recording method is preferable. Details of the inkjet recording method are as described above.

It is preferable to preheat the base material on which the insulating layer is formed, before applying the conductive ink. At the time of applying the conductive ink, the temperature of the base material is preferably 20°C to 120°C, and more preferably 40°C to 100°C.

It is preferable that the conductive ink be cured using heat or light after being applied onto the insulating layer.

In a case where the conductive ink is cured using heat, the baking temperature is preferably 250°C or lower, and the baking time is 1 minute to 120 minutes. In a case where the baking temperature and baking time are in the above ranges, the damage of the base material is suppressed.

The baking temperature is preferably 80°C to 250°C, and more preferably 100°C to 200°C. The baking time is preferably 1 minute to 60 minutes.

The baking method is not particularly limited, and a generally known method can be used.

The time from when the application of the conductive ink has finished to when baking is started is preferably 60 seconds or less. The lower limit of the time is not particularly limited, and is, for example, 20 seconds. In a case where the time is 60 seconds or less, the conductivity is improved.

"When the application of the conductive ink has finished" means a point in time when all the droplets of the conductive ink have been landed on the insulating layer.

In a case where the conductive ink is cured using light, examples of the light include ultraviolet rays and infrared rays.

The peak wavelength of the ultraviolet rays is preferably 200 nm to 405 nm, more preferably 250 nm to 400 nm, and even more preferably 300 nm to 400 nm.

The exposure amount during the light irradiation is preferably 100 mJ/cm² to 10,000 J/cm², and more preferably 500 mJ/cm² to 7,500 mJ/cm².

In the step of obtaining a conductive layer, in order to obtain a conductive layer having a desired thickness, it is preferable to repeat the step of applying the conductive ink two or more times, and it is more preferable to repeat the step of applying the conductive ink and curing the conductive ink two or more times. In a case where the step of applying the conductive ink is repeated two or more times, a dense conductive layer is formed, and the conductivity is improved.

The thickness of the conductive layer is preferably 0.1 µm to 100 µm, and more preferably 1 µm to 50 µm.

In the manufacturing method of a laminate of the present disclosure, the ratio of the thickness of the conductive layer to the thickness of the insulating layer (that is, "thickness of conductive layer/thickness of insulating layer") is preferably less than 0.5. In a case where the ratio is less than 0.5, the damage such as breakage does not occur in the insulating layer during the formation of the conductive layer, and the adhesiveness between the insulating layer and the conductive layer is improved. From the viewpoint of further improving the adhesiveness between the insulating layer and the conductive layer, the above ratio is more preferably less than 0.2. The lower limit of the ratio is not particularly limited, and is, for example, 0.01.

### [Laminate]

The laminate of the present disclosure includes a base material, an insulating layer provided on the base material, and a conductive layer provided on the insulating layer. The insulating layer is a cured substance of the insulating ink of the present disclosure. The conductive layer is a cured substance of the conductive ink of the present disclosure. The laminate manufactured using the ink set of the present disclosure has excellent conductivity.

### Examples

Hereinafter, the present disclosure will be more specifically described based on examples, but the present disclosure is not limited to the following examples as long as the gist of the present disclosure is maintained.

### <Preparation of insulating ink 1>

The following components were mixed together, and the mixture was stirred for 20 minutes at 25°C under the conditions of 5,000 rpm by using a mixer (trade name "L4R", manufactured by Silverson), thereby obtaining an insulating ink.
·Omni. 379: 2-(dimethylamino)-2-(4-methylbenzyl)-1-(4-morpholinophenyl)-butan-1-one (trade name "Omnirad 379", manufactured by IGM Resins B. V) IGM Resins B.V, Inc.)···4.0% by mass
·ITX: 2-isopropylthioxanthone (trade name "SPEEDCURE ITX", manufactured by Lambson Ltd.) ... 2.0% by mass
·PEA: phenoxyethyl acrylate (manufactured by FUJIFILM Wako Pure Chemical Corporation)···49.0% by mass
·NVC: N-vinylcaprolactam (manufactured by FUJIFILM Wako Pure Chemical Corporation)···22.0% by mass
·TMPTA: trimethylolpropane triacrylate (manufactured by FUJIFILM Wako Pure Chemical Corporation)···23.0% by mass

### <Insulating inks 2 to 22>

Insulating inks 2 to 22 were prepared by the same method as the insulating ink 1, except that the types and contents of the polymerization initiator, sensitizer, polymerizable monomer (a monofunctional polymerizable monomer and a polyfunctional polymerizable monomer), and other components are changed as described in Table 1.

Details of components used in the insulating inks 2 to 22 are as follows.

### -Polymerization initiator-

·Omni. 907: 2-methyl-1-[4-(methylthio)phenyl]-2-morpholinopropan-1-one (trade name "Omnirad 907", manufactured by IGM Resins B. V)
·Omni. 651: 2,2-dimethoxy-2-phenylacetophenone (trade name "Omnirad 651", manufactured by IGM Resins B. V)
·OXE01: 1-[4-(phenylthio)phenyl]-1,2-octanedione-2-(O-benzoyloxime) (trade name "Irgacure OXE01", manufactured by BASF Japan Ltd.)
·Irg. 784: di-η(5)-cyclopentadienylbis[2,6-difluoro-3-(pyrrol-1-yl)phenyl]titanium (IV) (trade name "Irgacure 784", manufactured by BASF SE)
·Omni. 127: 2,2'-dihydroxy-2,2'-dimethyl-1,1'-[methylenebis(4,1-phenylene)]bis(propan-1-one) (trade name "Omnirad 127", manufactured by IGM Resins B. V)
·TPO: 2,4,6-trimethylbenzoyldiphenylphosphine oxide (trade name "Omnirad TPO H", manufactured by IGM Resins B. V)
·4-PBZ: 4-phenylbenzophenone (trade name "Omnirad 4-PBZ", manufactured by IGM Resins B. V.)

### -Monofunctional polymerizable monomer-

·CTFA: Cyclic trimethylolpropane formal acrylate (trade name "SR-531", manufactured by Sartomer)
·EOEOEA: 2-(2-ethoxyethoxy)ethyl acrylate (manufactured by FUJIFILM Wako Pure Chemical Corporation)
·IBOA: isobornyl acrylate (trade name "SR506", manufactured by Sartomer)

### -Polyfunctional polymerizable monomer-

·HDDA: 1,6-hexanediol diacrylate (manufactured by FUJIFILM Wako Pure Chemical Corporation)
·NPGDA: neopentyl glycol diacrylate (trade name "SR-248", manufactured by Sartomer)
·EOTMPTA: trimethylolpropane EO-added triacrylate (trade name "SR-415", manufactured by Sartomer)

### -Surfactant-

·TR2010: polymerizable silicone surfactant (trade name "TEGORAD2010", manufactured by Evonik Industries AG)

### -Chain transfer agent-

• Pentaerythritol tetrakis(3-mercaptobutyrate) trade name "Karenz MT-PE1"

### -Polymerization Inhibitor-

·MEHQ: p-methoxyphenol (manufactured by FUJIFILM Wako Pure Chemical Corporation)

Table 1 shows the types and contents (% by mass) of the components contained in the insulating inks 1 to 22. In addition to the components listed in Table 1, the insulating ink 21 contains 20.0% by mass of the chain transfer agent and 1.0% by mass of the polymerization inhibitor.

**[Table 1]**

| | Polymerization initiator | | Sensitizer | | Monofunctional polymerizable monomer 1 | | Monofunctional polymerizable monomer 2 | | Polyfunctional polymerizable monomer 1 | | Polyfunctional polymerizable monomer 2 | | Surfactant | |
|---|---|---|---|---|---|---|---|---|---|---|---|---|---|---|
| | Type | Content (% by mass) | Type | Content (% by mass) | Type | Content (% by mass) | Type | Content (% by mass) | Type | Content (% by mass) | - | - | - | - |
| Insulating ink 1 | Omn.379 | 4.0 | ITX | 2.0 | PEA | 49.0 | NVC | 22.0 | TMPTA | 23.0 | - | - | - | - |
| Insulating ink 2 | Omn.379 | 2.0 | ITX | 2.0 | PEA | 51.0 | NVC | 22.0 | TMPTA | 23.0 | - | - | - | - |
| Insulating ink 3 | Omn.379 | 9.0 | ITX | 2.0 | PEA | 440 | NVC | 22.0 | TMPTA | 23.0 | - | - | - | - |
| Insulating ink 4 | Omn.907 | 4.0 | ITX | 2.0 | PEA | 49.0 | NVC | 220 | TMPTA | 23.0 | - | - | - | - |
| Insulating ink 5 | Omn.651 | 4.0 | ITX | 2.0 | PEA | 49.0 | NVC | 22.0 | TMPTA | 23.0 | | | | |
| Insulating ink 6 | OXE01 | 4.0 | ITX | 2.0 | PEA | 49.0 | NVC | 22.0 | TMPTA | 23.0 | - | - | - | - |
| Insulating ink 7 | Irg.784 | 4.0 | ITX | 2.0 | PEA | 49.0 | NVC | 22.0 | TMPTA | 23.0 | | | | |
| Insulating ink 8 | Omn.127 | 4.0 | ITX | 2.0 | PEA | 49.0 | NVC | 22.0 | TMPTA | 23.0 | - | - | - | - |
| Insulating ink 9 | Omn.379 | 4.0 | ITX | 2.0 | CTFA | 49.0 | NVC | 22.0 | EOTMPTA | 23.0 | - | - | - | - |
| Insulating ink 10 | Omn.379 | 4.0 | ITX | 2.0 | EOEOEA | 49.0 | NVC | 22.0 | HDDA | 23.0 | - | - | - | - |
| Insulating ink 11 | Omn.379 | 4.0 | - | - | PEA | 510 | NVC | 22.0 | TMPTA | 23.0 | - | - | - | - |
| Insulating ink 12 | Omn.379 | 4.0 | ITX | 2.0 | PEA | 72.0 | NVC | 22.0 | - | - | - | - | - | - |
| Insulating ink 13 | Omn.379 | 4.0 | ITX | 2.0 | PEA | 390 | NVC | 22.0 | TMPTA | 23.0 | HDDA | 10.0 | - | - |
| Insulating ink 14 | Omn.379 | 1.7 | ITX | 2.0 | PEA | 51.3 | NVC | 22 0 | TMPTA | 23.0 | - | - | - | - |
| Insulating ink | Omn.379 | 13.0 | ITX | 2.0 | PEA | 40.0 | NVC | 22.0 | TMPTA | 23.0 | - | - | - | - |
| Insulating ink 16 | Omn.379 | 4.0 | ITX | 2.0 | PEA | 41.0 | NVC | 12.0 | TMPTA | 23.0 | NPGDA | 180 | - | - |
| Insulating ink 17 | Omn.379 | 4.0 | ITX | 2.0 | PEA | 34.0 | NVC | 120 | TMPTA | 23.0 | NPGDA | 25.0 | | |
| Insulating ink 18 | Omn.379 | 4.0 | ITX | 2.0 | PEA | 29.0 | NVC | 120 | TMPTA | 23.0 | NPGDA | 30.0 | - | - |
| Insulating ink 19 | Omn.379 | 4.0 | ITX | 2.0 | PEA | 70.0 | - | - | TMPTA | 24.0 | - | - | - | - |
| Insulating ink 20 | Omn.379 | 4.0 | ITX | 2.0 | PEA | 48.5 | NVC | 22.0 | TMPTA | 23.0 | - | - | TR2010 | 0.5 |
| Insulating ink 21 | Omn.379 | 1.0 | - | - | IBOA | 30.0 | NVC | 15.0 | HDDA | 25.5 | - | - | - | - |
| | 4-PBZ | 7.5 | | | | | | | | | | | | |
| Insulating ink 22 | TPO | 4.0 | ITX | 2.0 | PEA | 49.0 | NVC | 22.0 | TMPTA | 23.0 | - | - | - | - |

### <Preparation of conductive ink 1>

1-Propanol (25.1 g), 20 g of silver acetate, and 5 g of formic acid were added to a 300 mL three-neck flask, and the mixture was stirred for 20 minutes. The generated silver salt precipitate was decanted 3 times by using 1-propanol and washed. 1-Propylamine (14.4 g) and 25.1 g of 1-propanol were added to the precipitate, and the mixture was stirred for 30 minutes. Then, 10 g of water was added thereto, and the mixture was further stirred, thereby obtaining a solution containing a silver complex. This solution was filtered using a membrane filter made of polytetrafluoroethylene (PTFE) having a pore diameter of 0.45 µm, thereby obtaining a conductive ink 1.

### <Preparation of conductive ink 2>

Water (46 g), 20.0 g of silver acetate, 20 g of ethylenediamine, and 20 g of amylamine were added to a 300 mL three-neck flask, and the mixture was stirred for 20 minutes. Formic acid (4 g) was added to the obtained solution, and the mixture was further stirred for 30 minutes, thereby obtaining a solution containing a silver complex. This solution was filtered using a membrane filter made of polytetrafluoroethylene (PTFE) having a pore diameter of 0.45 µm, thereby obtaining a conductive ink 2.

### <Preparation of conductive ink 3>

A conductive ink 3 was obtained by the same method as the conductive ink 1, except that the type and amount of complexing agent and the type and amount of solvent in the conductive ink 1 were changed as described in Table 2.

### <Preparation of conductive ink 4>

Dehydrated oxalic acid (30 g) was dissolved in 350 mL of water, thereby preparing an aqueous oxalic acid solution. Furthermore, 30 g of silver nitrate was dissolved in 120 mL of water, thereby preparing an aqueous silver nitrate solution. The aqueous silver nitrate solution was added dropwise to the aqueous oxalic acid solution with stirring. After the end of the reaction, silver oxalate as a precipitate was isolated. The isolated silver oxalate (18 g) and 36.50 g of ethanol were added to a 200 mL three-neck flask. In an ice bath, 36 g of isopropanolamine was added dropwise to the obtained suspension for 10 minutes. Octylamine (12.5 g) was added thereto, and the mixture was stirred at room temperature for 2 hours, thereby obtaining a solution containing a silver complex. Polyvinylpyrrolidone (1.2 g) was added to 98.8 g of the aforementioned complex solution. This solution was filtered using a membrane filter made of polytetrafluoroethylene (PTFE) having a pore diameter of 0.45 µm, thereby obtaining a conductive ink 4.

### <Preparation of conductive inks 5 to 7>

Conductive inks 5 to 7 were obtained by the same method as the conductive ink 4, except that in the conductive ink 4, the type and content of metal salt not yet forming a complex, the type and content of solvent, and the type of reducing agent are changed as described in Table 2.

### <Preparation of conductive ink 8>

Silver neodecanoate (40 g) was added to a 200 mL three-neck flask. Then, 30.0 g of trimethylbenzene and 30.0 g of terpineol were added thereto and stirred, thereby obtaining a solution containing a silver salt. This solution was filtered using a membrane filter made of polytetrafluoroethylene (PTFE) having a pore diameter of 0.45 µm, thereby obtaining a conductive ink 8.

### <Preparation of conductive ink 9>

Silver neodecanoate (25.0 g), 35 g of xylene, and 30.0 g of terpineol were added to a 200 mL three-neck flask, and dissolved. Then, 10 g of tert-octylamine was added thereto and stirred, thereby obtaining a solution containing a silver complex. The reaction was carried out at normal temperature for 2 hours, thereby obtaining a homogeneous solution. This solution was filtered using a membrane filter made of polytetrafluoroethylene (PTFE) having a pore diameter of 0.45 µm, thereby obtaining a conductive ink 9.

### <Preparation of conductive ink 10>

A conductive ink 10 was obtained by the same method as the conductive ink 9, except that tert-octylamine in the conductive ink 9 was changed to amylamine.

### <Preparation of conductive ink 11>

A conductive ink 11 was obtained by the same method as the conductive ink 9, except that 1 g of tert-octylamine in the conductive ink 9 was changed to 0.5 g of amylamine and 0.5 g of octylamine.

### <Preparation of conductive ink 12>

Isobutylammonium carbonate (26.14 g) and 64.0 g of isopropyl alcohol were added to a 200 mL three-neck flask, and dissolved. Then, 9.0 g of silver oxide was added thereto and reacted at normal temperature for 2 hours, thereby obtaining a homogeneous solution. Furthermore, 1.29 g of 2-hydroxy-2-methylpropylamine was added thereto and stirred, thereby obtaining a solution containing a silver complex. This solution was filtered using a membrane filter made of polytetrafluoroethylene (PTFE) having a pore diameter of 0.45 µm, thereby obtaining a conductive ink 12.

### <Preparation of conductive ink 13>

A conductive ink 13 was obtained by the same method as the conductive ink 3, except that the amount of complexing agent and the amount of reducing agent in the conductive ink 3 were changed as described in Table 2.

### <Preparation of conductive ink 14>

As a dispersant, 6.8 g of polyvinylpyrrolidone (weight-average molecular weight 3,000, manufactured by Sigma-Aldrich Corporation) was dissolved in 100 mL of water, thereby preparing a solution a. In addition, 50.00 g of silver nitrate was dissolved in 200 mL of water, thereby preparing a solution b. The solution a and the solution b were mixed together and stirred, thereby obtaining a mixed solution. At room temperature, 78.71 g of an 85% by mass aqueous N,N-diethylhydroxylamine solution was added dropwise to the mixed solution. In addition, a solution obtained by dissolving 6.8 g of polyvinylpyrrolidone in 1,000 mL of water was slowly added dropwise to the mixed solution at room temperature. The obtained suspension was passed through an ultrafiltration unit (Vivaflow 50 manufactured by Sartorius Stedim Biotech GmbH., molecular weight cut-off: 100,000, number of units: 4) and purified by being passed through purified water until about 5 L of exudate is discharged from the ultrafiltration unit. The supply of purified water was stopped, followed by concentration, thereby obtaining 30 g of a silver particle dispersion liquid 1. The content of solids in this dispersion is 50% by mass. The content of silver in the solids that was measured by TG-DTA (simultaneous measurement of thermogravimetry and differential thermal analysis) (manufactured by Hitachi High-Tech Corporation., model: STA7000 series) was 96.0% by mass. The obtained silver particle dispersion liquid 1 was 20X diluted with deionized water, and measured using a particle size analyzer FPAR-1000 (manufactured by Otsuka Electronics Co., Ltd) to determine the volume-average particle diameter of the silver particles. The volume-average particle diameter of the silver particle dispersion liquid 1 was 60 nm.

2-Propanol (2 g) and 0.1 g of OLFINE E-1010 (manufactured by Nissin Chemical Industry Co., Ltd.) as a surfactant were added to 10 g of the silver particle dispersion liquid, and water was added thereto such that the silver concentration reaches 40% by mass, thereby obtaining a conductive ink 14.

Table 2 shows the types and contents (% by mass) of the components contained in the conductive inks 1 to 14. First, whether the metal compound contained in each conductive ink is a metal complex, a metal salt, or metal particles is described table. Furthermore, in a case where the metal compound is a metal complex, the type of metal salt not yet forming a complex and the type of complexing agent are also described in the table.

Details of the abbreviations in Table 2 are as follows.
-Complexing agent-
   PA: 1-propylamine
   EDA: ethylenediamine
   EA: ethylamine
   iPrOHA: isopropanolamine
   AA: amylamine
   EtOHA: ethanolamine
   OA: octylamine
   2HMPA: 2-hydroxy-2-methylpropylamine
   tOA: t-octylamine
   IBAC: Isobutylammonium carbonate
-Solvent-
   1PrOH: 1-propanol
   H₂O: water
   MeOH: methanol
   EtOH: ethanol
   IPA: isopropanol
   TO: terpineol
   TMB: trimethylbenzene
   XL: xylene
-Reducing agent-
   FA: formic acid
-Resin-
   PVP: polyvinylpyrrolidone

**[Table 2]**

| | Form | Metal salt | | Complexing agent 1 | | Complexing agent 2 | | Solvent 1 | | Solvent 2 | | Reducing agent | | Resin | |
|---|---|---|---|---|---|---|---|---|---|---|---|---|---|---|---|
| | | Type | Content (% by mass) | Type | Content (% by mass) | Type | Content (% by mass) | Type | Content (% by mass) | Type | Content (% by mass) | Type | Content (% by mass) | Type | Content (% by mass) |
| Conductive ink 1 | Metal complex | Silver acetate | 20 | PA | 144 | - | - | 1PrOH | 50.2 | H₂O | 10.0 | FA | 5.0 | - | - |
| Conductive ink 2 | Metal complex | Silver acetate | 20 | EDA | 20 | AA | 10.0 | H₂O | 46.0 | - | - | FA | 40 | - | - |
| Conductive ink 3 | Metal complex | Silver acetate | 20 | EA | 3.6 | EtOHA | 15.0 | MeOH | 40.4 | H₂O | 19.0 | FA | 2.0 | - | - |
| Conductive ink 4 | Metal complex | Silver oxalate | 18 | iPrOHA | 36 | OA | 9.0 | EtOH | 35.9 | - | - | - | - | PVP | 1.2 |
| Conductive ink 5 | Metal complex | Silver acetate | 20 | iPrOHA | 36 | OA | 9.0 | EtOH | 33.8 | - | - | - | - | PVP | 1.2 |
| Conductive ink 6 | Metal complex | Silver acetate | 20 | iPrOHA | 36 | OA | 9.0 | EtOH | 34.5 | - | - | FA | 0.5 | - | - |
| Conductive ink 7 | Metal complex | Silver acetate | 20 | iPrOHA | 36 | OA | 9.0 | H₂O | 34.5 | - | - | FA | 0.5 | - | - |
| Conductive ink 8 | Metal salt | Silver neodecanoate | 40 | - | - | - | - | TMB | 30.0 | TO | 30.0 | - | - | - | - |
| Conductive ink 9 | Metal complex | Silver neodecanoate | 25 | tOA | 10 | - | - | XL | 35.0 | TO | 30.0 | - | - | - | - |
| Conductive ink 10 | Metal complex | Silver neodecanoate | 25 | AA | 10 | - | - | XL | 35.0 | TO | 30.0 | - | - | - | - |
| Conductive ink 11 | Metal complex | Silver neodecanoate | 25 | AA | 5 | OA | 5.0 | XL | 35.0 | TO | 30.0 | - | - | - | - |
| Conductive ink 12 | Metal complex | Silver oxide | 8.6 | IBAC | 26.11 | 2HMPA | 1.29 | IPA | 64.0 | - | - | - | - | - | - |
| Conductive ink 13 | Metal complex | Silver acetate | 20 | EA | 3.6 | EtOHA | 6.0 | MeOH | 40.4 | H₂O | 29.0 | FA | 1.0 | - | - |
| Conductive ink 14 | Metal complex | | | | | | | | | | | | | | |

### [Example 1]

### -Preparation of laminate sample 1-

As a base material, a polyethylene terephthalate film (trade name "Viewful UV TP-100", manufactured by KIMOTO) was prepared. The ink cartridge (for 10 picoliters) for an inkjet recording device (trade name "DMP-2850", manufactured by Fujifilm Dimatix Inc) was filled with the insulating ink 1. As image recording conditions, the resolution was set to 1,270 dots per inch (dpi), and the jetting amount was set to 10 picoliters/dot. An ultraviolet lamp-type irradiator (trade name "UV SPOT CURE OmniCure S2000", manufactured by Lumen Dynamics Group Inc.) was prepared next to the ink jet head. An operation of performing exposure while recording an image on the base material was repeated such that four layers were laminated, and a solid image having a width of 10 cm, a length of 5 cm, and a thickness of 100 µm was recorded, thereby forming an insulating layer.

Then, the ink cartridge (for 10 picoliters) for an ink jet recording device (trade name "DMP-2850", manufactured by Fujifilm Dimatix Inc) was filled with the conductive ink 1. As image recording conditions, the resolution was set to 1,270 dots per inch (dpi), and the jetting amount was set to 6 picoliters/dot. The base material on which the insulating layer was formed was preheated to 50°C. On the base material at 50°C, a solid image was recorded such that this image overlapped the aforementioned solid image. After a lapse of 10 seconds from when the last ink droplet was landed on the base material, the solid image was heated at 120°C for 20 minutes by using a hot plate. This operation was repeated 4 times, thereby obtaining a laminate sample 1 composed of an insulating layer and a 1.0 µm thick conductive layer having metallic gloss formed on the insulating layer.

### -Preparation of laminate sample 2-

A solid image having a width of 2.5 cm, a length of 2.5 cm, and a thickness of 100 µm was recorded on a base material by using the insulating ink 1 by the same method as the method of preparing the laminate sample 1, except that a print substrate was used as a base material. Furthermore, by using the conductive ink 1, a laminate sample 2 composed of an insulating layer and a 1.0 µm thick conductive layer having metallic gloss formed on the insulating layer was obtained by the same method as the method of preparing the laminate sample 1.

### [Examples 2 to 7 and 9 to 32 and Comparative Example 1]

The laminate samples 1 and 2 were prepared by the same method as in Example 1, except that the types of insulating ink and conductive ink were changed as described in Table 3.

### [Example 8 and Comparative Example 2]

The laminate samples 1 and 2 were prepared by the same method as in Example 1, except that the types of insulating ink and conductive ink were changed as described in Table 3, and the heating temperature of the solid image recorded using the conductive ink was changed to 150°C from 120°C.

By using the laminate samples 1 and 2 obtained in each of the examples and comparative examples, the evaluation regarding the conductivity, the adhesiveness between the insulating layer and the conductive layer, the adhesiveness with the base material, and the uniformity of the conductive layer was carried out. Furthermore, in preparing the laminate sample 1, the contact angle of the conductive ink on the insulating layer was measured. The measuring method and the evaluation method are as follows. Table 3 shows the measurement results and the evaluation results.

### <Contact angle>

In preparing the laminate sample 1, the conductive ink was added dropwise onto the insulating layer, and the contact angle was measured using a contact angle meter (trade name: "Drop master 500", manufactured by Kyowa Interface Science Co., Ltd.).

### <Conductivity>

For the conductive layer in the laminate sample 1, by using a resistivity meter (trade name "Loresta GP", manufactured by Mitsubishi Chemical Analytech Co., Ltd.), the surface resistivity [Q/square] was measured at room temperature (23°C) by a 4-terminal method. The evaluation standard is as follows. The conductive layer ranked 2 or higher is at a level having no problem for practical use.
5: The surface resistivity is less than 100 mQ/square.
4: The surface resistivity is 100 mQ/square or more and less than 250 mS2/square.
3: The surface resistivity is 250 mQ/square or more and less than 500 mQ/square.
2: The surface resistivity is 500 mQ/square or more and less than 1 S2/square.
1: The surface resistivity is 1 S2/square or more.

### <Adhesiveness between insulating layer and conductive layer ("Adhesiveness A" in table)>

After being prepared, the laminate sample 1 was left at 25°C for 1 hour. After 1 hour, a piece of CELLOTAPE (registered trademark, No. 405, manufactured by NICHIBAN Co., Ltd., width 12 mm, also simply called "tape" hereinafter) was attached onto the conductive layer of the laminate sample 1. Then, the piece of tape was peeled off from the image to evaluate the adhesiveness between the insulating layer and the conductive layer.

Specifically, the tape was attached and peeled off by the following method.

The tape was unwound at a constant speed and cut in a length of about 75 mm, thereby obtaining a piece of tape.

The obtained piece of tape was stacked on the conductive layer of the laminate sample 1, and the central region of the piece of tape having a width of 12 mm and a length of 25 mm was attached with a finger and rubbed hard with a fingertip.

After the piece of tape was attached, the end of the piece of tape was grasped and peeled off for 0.5 seconds to 1.0 seconds at an angle as close to 60° as possible.

Whether or not the peeled piece of tape had an attachment and whether or not the conductive layer in the laminate sample 1 was peeled off were visually observed. The adhesiveness between the insulating layer and the conductive layer was evaluated according to the following evaluation standard. The evaluation standard is as follows. Table 3 shows the evaluation results.
5: The piece of tape is found to have no attachment, and peeling of the conductive layer is not observed.
4: Although the piece of tape is found to have few attachments, peeling of the conductive layer is not observed.
3: Although the piece of tape is found to have few attachments, and the conductive layer is found to be slightly peeled off, the attachments and the peeling are within an acceptable range for practical use.
2: The piece of tape is found to have attachment, and the conductive layer is found to be peeled off, which are out of an acceptable range for practical use.
1: The piece of tape is found to have attachment, most of the conductive layer is peeled off, and the insulating layer is visible.

### <Adhesiveness between base material and insulating layer ("Adhesiveness B" in table)>

By using the laminate sample 2, the adhesiveness between the base material and the insulating layer was evaluated by the same method as the evaluation method of the adhesiveness between the insulating layer and the conductive layer. The evaluation standard is as follows. Table 3 shows the evaluation results.
5: The piece of tape is found to have no attachment, and peeling between the base material and the insulating layer is not observed.
4: Although the piece of tape is found to have few attachments, peeling between the base material and the insulating layer is not observed.
3: Although the piece of tape is found to have few attachments, and peeling between the base material and the insulating layer is observed, the attachments and the peeling are within an acceptable range for practical use.
2: The piece of tape is found to have attachment, and peeling between the base material and the insulating layer is also observed, which are out of an acceptable range for practical use.
1: The piece of tape is found to have attachment, the base material and the insulating layer are substantially completely peeled off, and the base material is visible.

### <Uniformity of conductive layer ("Uniformity" in table)>

For the conductive ink film in the laminate sample 1, by using a resistivity meter (trade name "Loresta GP", manufactured by Mitsubishi Chemical Analytech Co., Ltd.), the surface resistivity [Q/square] was measured at room temperature (23°C) by a 4-terminal method. The surface resistivity was measured at eight random sites of the conductive layer, and the standard deviation was calculated. In a case where the standard deviation was 150 mQ/square or more, the surface of the conductive layer was visually observed to determine whether the surface has unevenness. The evaluation standard is as follows. The conductive ink film ranked 2 or higher is at a level having no problem for practical use.
5: The standard deviation is less than 50 mQ/square.
4: The standard deviation is 50 mQ/square or more and less than 150 mQ/square.
3: The standard deviation is 150 mQ/square or more, and surface unevenness is not observed.
2: The standard deviation is 150 mQ/square or more, and surface unevenness is not observed.
1: The conductive layer is not uniform, and it is difficult to measure the surface resistivity.

In Table 3, regarding the insulating ink, the type of insulating ink, the type and content of polymerization initiator contained in the insulating ink, the content of a N-vinyl compound contained in the insulating ink, and the polyfunctional ratio are described. The polyfunctional ratio means the proportion of the polyfunctional polymerizable monomer in the polymerizable monomer contained in the insulating ink. Regarding the conductive ink, the type of conductive ink and the contact angle on the insulating layer are described. "Ratio of mass of polymerization initiator to total mass of carboxylic acid and amine" means the ratio of the mass of the polymerization initiator contained in the insulating ink to the total mass of the carboxylic acid and the amine in the conductive ink.

**[Table 3]**

| | Insulating ink | | | | | Conductive ink | | Ratio of mass of polymerization initiator to total mass of carboxylic acid and amine | Evaluation | | | |
|---|---|---|---|---|---|---|---|---|---|---|---|---|
| | Type | Polymerization initiator | | N-vinyl compound | Polyfunctional ratio (% by mass) | Type | Contact angle (°) | | Conductivity | Adhesiveness A | Adhesiveness B | Uniformity |
| | | Type | Content (% by mass) | Content (% by mass) | | | | | | | | |
| Example 1 | Insulating ink 1 | Omn.379 | 4.0 | 22.0 | 24.5 | Conductive ink 1 | 28 | 0.15 | 5 | 5 | 5 | 5 |
| Example 2 | Insulating ink 1 | Omn.379 | 4.0 | 22.0 | 24.5 | Conductive ink 2 | 30 | 0.10 | 5 | 5 | 5 | 5 |
| Example 3 | Insulating ink 1 | Omn.379 | 4.0 | 22.0 | 24.5 | Conductive ink 3 | 25 | 0.14 | 5 | 5 | 5 | 5 |
| Example 4 | Insulating ink 1 | Omn.379 | 4.0 | 22.0 | 24.5 | Conductive ink 4 | 26 | 0.08 | 5 | 5 | 5 | 5 |
| Example 5 | Insulating ink 1 | Omn.379 | 4.0 | 22.0 | 24.5 | Conductive ink 5 | 25 | 0.08 | 5 | 5 | 5 | 5 |
| Example 6 | Insulating ink 1 | Omn.379 | 4.0 | 22.0 | 24.5 | Conductive ink 6 | 25 | 0.08 | 5 | 5 | 5 | 5 |
| Example 7 | Insulating ink 1 | Omn.379 | 4.0 | 22.0 | 24.5 | Conductive ink 7 | 30 | 0.08 | 5 | 5 | 5 | 5 |
| Example 8 | Insulating ink 1 | Omn.379 | 4.0 | 22.0 | 24.5 | Conductive ink 8 | 23 | 0.16 | 5 | 5 | 5 | 5 |
| Example 9 | Insulating ink 1 | Omn.379 | 4.0 | 22.0 | 24.5 | Conductive ink 9 | 22 | 0.16 | 5 | 5 | 5 | 5 |
| Example 10 | Insulating ink 1 | Omn.379 | 4.0 | 22.0 | 24.5 | Conductive ink 10 | 22 | 0.16 | 5 | 5 | 5 | 5 |
| Example 11 | Insulating ink 1 | Omn.379 | 4.0 | 22.0 | 24.5 | Conductive ink 11 | 22 | 0.16 | 5 | 5 | 5 | 5 |
| Example 12 | Insulating ink 1 | Omn.379 | 4.0 | 22.0 | 24.5 | Conductive ink 12 | 23 | 0.15 | 5 | 5 | 5 | 5 |
| Example 13 | Insulating ink 2 | Omn.379 | 2.0 | 22.0 | 24.0 | Conductive ink 7 | 29 | 0.04 | 5 | 4 | 5 | 5 |
| Example 14 | Insulating ink 3 | Omn.379 | 9.0 | 22.0 | 25.8 | Conductive ink 13 | 26 | 0.51 | 4 | 5 | 5 | 5 |
| Example 15 | Insulating ink 4 | Omn.907 | 4.0 | 22.0 | 245 | Conductive | 30 | 0.08 | 5 | 5 | 5 | 5 |
| Example 16 | Insulating ink 5 | Omn.651 | 4.0 | 22.0 | 24.5 | Conductive ink 7 | 30 | 0.08 | 5 | 5 | 5 | 5 |
| Example 17 | Insulating ink 6 | OXE01 | 4.0 | 22.0 | 24.5 | Conductive ink 7 | 30 | 0.08 | 4 | 4 | 5 | 5 |
| Example 18 | Insulating ink 7 | Irg.784 | 4.0 | 22.0 | 24.5 | Conductive ink 7 | 30 | 0.08 | 4 | 4 | 5 | 5 |
| Example 19 | Insulating ink 8 | Omn.127 | 4.0 | 22.0 | 24.5 | Conductive ink 7 | 30 | 0.08 | 4 | 5 | 5 | 5 |
| Example 20 | Insulating ink 9 | Omn.379 | 4.0 | 22.0 | 24.5 | Conductive ink 7 | 30 | 0.08 | 5 | 5 | 5 | 5 |
| Example 21 | Insulating ink 10 | Omn.379 | 4.0 | 22.0 | 24.5 | Conductive ink 7 | 30 | 0.08 | 5 | 5 | 5 | 5 |
| Example 22 | Insulating ink 11 | Omn.379 | 4.0 | 22.0 | 24.0 | Conductive ink 7 | 30 | 0.08 | 5 | 5 | 5 | 5 |
| Example 23 | Insulating ink 12 | Omn.379 | 4.0 | 22.0 | 0 | Conductive ink 7 | 30 | 0.08 | 5 | 5 | 5 | 5 |
| Example 24 | Insulating ink 13 | Omn.379 | 4.0 | 22.0 | 35.1 | Conductive ink 7 | 30 | 0.08 | 5 | 5 | 5 | 5 |
| Example 25 | Insulating ink 14 | Omn.379 | 1.7 | 22.0 | 23.9 | Conductive ink 7 | 29 | 0.08 | 4 | 3 | 4 | 5 |
| Example 26 | Insulating ink 15 | Omn.379 | 13.0 | 22.0 | 27.1 | Conductive ink 7 | 30 | 0.25 | 4 | 4 | 5 | 5 |
| Example 27 | Insulating ink 16 | Omn.379 | 4.0 | 12.0 | 43.6 | Conductive ink 7 | 30 | 0.08 | 5 | 5 | 5 | 5 |
| Example 28 | Insulating ink 17 | Omn.379 | 4.0 | 12.0 | 51.1 | Conductive ink 7 | 30 | 0.08 | 5 | 5 | 3 | 5 |
| Example 29 | Insulating ink 18 | Omn.379 | 4.0 | 12.0 | 56.4 | Conductive ink 7 | 30 | 0.08 | 5 | 4 | 3 | 5 |
| Example 30 | Insulating ink 19 | Omn.379 | 4.0 | - | 25.5 | Conductive ink 7 | 30 | 0.08 | 4 | 4 | 4 | 5 |
| Example 31 | Insulating ink 20 | Omn.379 | 4.0 | 22.0 | 24.6 | Conductive ink 7 | 62 | 0.08 | 5 | 5 | 5 | 3 |
| Example 32 | Insulating ink 21 | Omn.379 | 1.0 | 15.0 | 36.2 | Conductive ink 1 | 32 | 0.32 | 5 | 5 | 5 | 5 |
| | | 4-PBZ | 7.5 | | | | | | | | | |
| Comparative Example 1 | Insulating ink 22 | TPO | 4.0 | 22.0 | 24.5 | Conductive ink 8 | 30 | 0.08 | 1 | 3 | 5 | 5 |
| Comparative Example 2 | Insulating ink 1 | Omn.379 | 4.0 | 22.0 | 24.5 | Conductive ink 14 | 30 | - | 2 | 5 | 5 | 5 |

As shown in Table 3, it has been found that in Examples 1 to 32, because the insulating ink contains at least one polymerization initiator selected from the group consisting of an oxime compound, an alkylphenone compound, and a titanocene compound and a polymerizable monomer, and the conductive ink contains at least one of a metal complex or a metal salt, a laminate having excellent conductivity is obtained.

On the other hand, it has been found that in Comparative Example 1, because the insulating ink does not contain at least one polymerization initiator selected from the group consisting of an oxime compound, an alkylphenone compound, and a titanocene compound, the obtained laminate has poor conductivity.

It has been found that in Comparative Example 2, because the conductive ink does not contain at least one of a metal complex or a metal salt, the obtained laminate has poor conductivity.

It has been found that in Example 7, because the insulating ink contains an alkylphenone compound as a polymerization initiator, the obtained laminate has higher conductivity and higher adhesiveness between the insulating layer and the conductive layer, compared to Examples 17 and 18.

It has been found that in Examples 7, 15, and 16, because the insulating ink contains at least one compound selected from the group consisting of an α-aminoalkylphenone compound and a benzyl ketal alkylphenone compound as a polymerization initiator, the obtained laminate has higher conductivity, compared to Example 19.

It has been found that in Example 7, because the content of at least one polymerization initiator selected from the group consisting of an oxime compound, an alkylphenone compound, and a titanocene compound is 2% by mass to 10% by mass, the obtained laminate has higher conductivity and higher adhesiveness between the insulating layer and the conductive layer, compared to Example 26 in which the content of the aforementioned polymerization initiator is more than 10% by mass. It has been found that in Example 7, the obtained laminate has higher conductivity, higher adhesiveness between the insulating layer and the conductive layer, and higher adhesiveness between the base material and the insulating layer, compared to Example 25 in which the content of the aforementioned polymerization initiator is less than 2% by mass.

It has been found that in Example 7, the proportion of the polyfunctional polymerizable monomer in the polymerizable monomer is 50% by mass or less, and the obtained laminate has higher adhesiveness between the base material and the insulating layer, compared to Examples 28 and 29.

It has been found that in Example 7, the insulating ink contains an N-vinyl compound, and the obtained laminate has higher conductivity, higher adhesiveness between the insulating layer and the conductive layer, and higher adhesiveness between the base material and the insulating layer, compared to Example 30.

It has been found that in Example 7, the contact angle of the conductive ink on the insulating layer is 60° or less, and the obtained laminate has a conductive layer having higher uniformity, compared to Example 31.

It has been found that in Example 1, the ratio of the mass of the polymerization initiator contained in the insulating ink to the total mass of the carboxylic acid and the amine in the conductive ink is 0.06 to 0.5, and the obtained laminate has higher adhesiveness between the insulating layer and the conductive layer, compared to Example 13 in which the aforementioned ratio is less than 0.06.

It has been found that in Example 1, the ratio of the mass of the polymerization initiator contained in the insulating ink to the total mass of the carboxylic acid and the amine in the conductive ink is 0.06 to 0.5, and the obtained laminate has higher conductivity, compared to Example 14 in which the aforementioned ratio is more than 0.5.

In the above examples, in preparing the laminate sample 1, the conductive ink was cured using heat. Hereinbelow, an example in which the conductive ink is cured using light will be described.

### [Example 33]

### -Preparation of laminate sample 3-

By using the insulating ink 1, an insulating layer was formed on the base material by the same method as in the preparation of the laminate sample 1.

Then, the ink cartridge (for 10 picoliters) for an ink jet recording device (trade name "DMP-2850", manufactured by Fujifilm Dimatix Inc) was filled with the conductive ink 3. As image recording conditions, the resolution was set to 1,270 dots per inch (dpi), and the jetting amount was set to 10 picoliters/dot. The base material on which the insulating layer was formed was preheated to 50°C. On the base material at 50°C, a solid image was recorded such that this image overlapped the aforementioned solid image. After a lapse of 10 seconds from when the last ink droplet was landed on the base material, by using a pulsed light generator (trade name "PulseForge3300", manufactured by NovaCentrix.), the conductive ink was irradiated three times at an output of 600 V and a pulse width of 50 µsec. This operation was repeated 4 times, thereby obtaining a laminate sample 3 composed of an insulating layer and a 1.3 µm thick conductive layer having metallic gloss formed on the insulating layer.

### -Preparation of laminate sample 4-

By using the insulating ink 1, an insulating layer was formed on the base material by the same method as in the preparation of the laminate sample 1.

Then, the ink cartridge (for 10 picoliters) for an ink jet recording device (trade name "DMP-2850", manufactured by Fujifilm Dimatix Inc) was filled with the conductive ink 3. As image recording conditions, the resolution was set to 1,270 dots per inch (dpi), and the jetting amount was set to 10 picoliters/dot. An ultraviolet lamp-type irradiator (trade name "UV SPOT CURE OmniCure S2000", manufactured by Lumen Dynamics Group Inc.) was prepared next to the ink jet head, and the illuminance was adjusted to 10 W/cm². The base material on which the insulating ink layer was formed was preheated to 50°C. On the base material at 50°C, a solid image was recorded with exposure such that this image overlapped the aforementioned solid image. The exposure amount was adjusted to 12 J/cm². This operation was repeated 4 times, thereby obtaining a laminate sample 4 composed of an insulating layer and a 1.3 µm thick conductive layer having metallic gloss formed on the insulating layer.

By using each of the laminate samples 3 and 4, the conductivity, the adhesiveness between the insulating layer and the conductive layer, the adhesiveness between the base material and the insulating layer, and the uniformity of the conductive layer were evaluated. The evaluation method is the same as described above.

As a result of evaluation, both the laminate samples 3 and 4 ranked 5 in terms of the conductivity, the adhesiveness between the insulating layer and the conductive layer, the adhesiveness between the base material and the insulating layer, and the uniformity of the conductive layer.

The entire disclosure of US63,085,155B, filed September 30, 2020, is incorporated into the present specification by reference. In addition, all documents, patent applications, and technical standards described in the present specification are incorporated into the present specification by reference, as if each of the documents, the patent applications, and the technical standards is specifically and individually described.

## Claims

1. An ink set comprising:
an insulating ink that comprises; at least one polymerization initiator selected from the group consisting of an oxime compound, an alkylphenone compound, and a titanocene compound and a polymerizable monomer; and
a conductive ink that comprises at least one of a metal complex or a metal salt.

2. The ink set according to claim 1,
wherein the polymerization initiator is an alkylphenone compound.

3. The ink set according to claim 1 or 2,
wherein the polymerization initiator is at least one compound selected from the group consisting of an α-aminoalkylphenone compound and a benzyl ketal alkylphenone compound.

4. The ink set according to any one of claims 1 to 3,
wherein the insulating ink has a content of the polymerization initiator of 2% by mass to 10% by mass with respect to a total amount of the insulating ink.

5. The ink set according to any one of claims 1 to 4,
wherein a proportion of a polyfunctional polymerizable monomer in the polymerizable monomer is 50% by mass or less.

6. The ink set according to any one of claims 1 to 5,
wherein the insulating ink comprises an N-vinyl compound.

7. The ink set according to any one of claims 1 to 6,
wherein a contact angle of the conductive ink on an insulating layer to be formed of the insulating ink is 60° or less.

8. The ink set according to any one of claims 1 to 7,
wherein the metal complex has a structure derived from at least one compound selected from the group consisting of an ammonium carbamate compound, an ammonium carbonate compound, an amine, and a carboxylic acid having 8 to 20 carbon atoms, and
the metal salt is a metal carboxylate.

9. The ink set according to any one of claims 1 to 8,
wherein the insulating ink and the conductive ink of the same mass provide a ratio of a mass of the polymerization initiator comprised in the insulating ink to a total mass of a carboxylic acid and an amine in the conductive ink of 0.06 to 0.5.

10. The ink set according to any one of claims 1 to 9,
wherein the ink set is used for a printed substrate.

11. A method of manufacturing a laminate using the ink set according to any one of claims 1 to 10, the method comprising:
a step of obtaining an insulating layer by applying the insulating ink onto a base material; and
a step of obtaining a conductive layer by applying the conductive ink onto the insulating layer.

12. The method of a laminate according to claim 11,
wherein a ratio of a thickness of the conductive layer to a thickness of the insulating layer is less than 0.5.

13. The method of a laminate according to claim 11 or 12,
wherein in the step of obtaining a conductive layer, the conductive ink is applied and then cured using heat or light.

14. The method of a laminate according to any one of claims 11 to 13,
wherein in the step of obtaining a conductive layer, a step of applying the conductive ink is repeated two or more times.

15. A laminate using the ink set according to any one of claims 1 to 10, the laminate comprising:
a base material;
an insulating layer that is a cured substance of the insulating ink provided on the base material; and
a conductive layer that is a cured substance of the conductive ink provided on the insulating layer.
